(19) Europäisches Patentamt / European Patent Office / Office européen des brevets

(11) **EP 2 237 310 A1**

(12) **EUROPEAN PATENT APPLICATION**
published in accordance with Art. 153(4) EPC

(43) Date of publication:
**06.10.2010 Bulletin 2010/40**

(51) Int Cl.:
***H01L 21/205*** (2006.01)  ***C23C 16/505*** (2006.01)

(21) Application number: **08839658.5**

(22) Date of filing: **08.09.2008**

(86) International application number:
**PCT/JP2008/066171**

(87) International publication number:
**WO 2009/050958 (23.04.2009 Gazette 2009/17)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **17.10.2007 JP 2007269853**

(71) Applicant: **Murata, Masayoshi**
**Nagasaki 852-8027 (JP)**

(72) Inventor: **Murata, Masayoshi**
**Nagasaki 852-8027 (JP)**

(74) Representative: **Pohlmann, Bernd Michael**
**Reinhardt & Pohlmann**
**Patentanwälte**
**Rossmarkt 12**
**60311 Frankfurt am Main (DE)**

(54) **HIGH FREQUENCY PLASMA CVD APPARATUS, HIGH FREQUENCY PLASMA CVD METHOD AND SEMICONDUCTOR THIN FILM MANUFACTURING METHOD**

(57) Provided are large area and uniform VHF plasma CVD apparatus and method wherein a plasma generating source constitutes the VHF plasma CVD apparatus for manufacturing a tandem-type thin film silicon solar cell, and influences of standing waves, generation of harmful plasma other than between a pair of electrodes and supply power consumption other than between the pair of electrodes are suppressed. First and second power feed points are arranged on an electrode at positions facing each other. A distance between the power feed points is set at an integral multiple of a half of the wavelength of the using power, and a pulse power separated in terms of time is supplied. The pulse power is outputted from two phase-variable double output high frequency power supplies which can perform pulse modulation. Thus, a first standing wave wherein the anti-node position matches with positions of the first and the second power feed points, and a second standing wave wherein the node position matches with positions of the first and the second power feed points are alternately generated in terms of time.

FIG.6

**Description**

Technical Field

The present invention relates to a high-frequency plasma CVD apparatus, high-frequency plasma CVD method, and semiconductor thin-film manufacturing method that are used in the manufacture of integrated tandem-type thin-film solar cells (termed as "tandem thin-film solar cells", hereafter), in particular, to a VHF plasma CVD apparatus and VHF plasma CVD method, where the frequency is 30 MHz to 300 MHz (VHF band).
In addition, the present invention relates to a high-frequency plasma CVD apparatus and a high-frequency plasma CVD method used in the manufacture of various apparatuses that apply micro-nano-crystalline (termed generally as "microcrystalline" herein) silicon film and crystalline silicon film.

Background Art

In a multi-junction photoelectric conversion element that laminates a plurality of semiconductor photoelectric conversion units having a photoelectric conversion function, the combination of a top cell and a bottom cell having different wavelength absorption bands is known to be very effective in improving the power conversion efficiency.
This designs for further improvement in the power conversion efficiency by having a spectrum distribution function in each coupling unit of the incident light energy in each transparent intermediate layer, for example, a function that reflects short-wavelength light and transmits long-wavelength light.
Specifically, an integrated tandem thin-film silicon solar cell is formed by sequentially laminating a transparent electrode layer, an amorphous silicon photoelectric conversion unit layer, an intermediate layer having the functions of reflecting short-wavelength light and transmitting long-wavelength light, a crystalline silicon photoelectric conversion unit layer, and a rear surface electrode layer on a light transmitting substrate (for example, glass).
The amorphous silicon photoelectric conversion unit layer is comprised of a p-type semiconductor layer, an i-type semiconductor layer, and an n-type semiconductor layer. The thickness is approximately 0.5 $\mu$m or less for the entire pin layer.
The crystalline silicon photoelectric conversion unit layer is comprised of a p-type microcrystalline semiconductor layer, an i-type microcrystalline semiconductor layer, and an n-type microcrystalline semiconductor layer. The thickness is approximately 3 to 5 $\mu$m for the entire pin layer. The thickness of the i-type microcrystalline semiconductor layer is approximately 2 to 4 $\mu$m.
A manufacturing line for manufacturing a solar cell that combines amorphous silicon and crystalline silicon referred to as the integrated tandem thin-film solar cell is expected to enable manufacturing a high efficiency module having a photoelectric conversion efficiency of a level of 10 to 13%.
However, in contrast to the advantage of the ease in improving the photoelectric conversion efficiency of the integrated tandem-type thin-film silicon solar cell, the disadvantages are that a very long time is required to manufacture the i-type microcrystalline semiconductor layer of the crystalline silicon photoelectric conversion unit layer required to be approximately 2- to 4-$\mu$m thick; or that multiple installations of the manufacturing apparatus for the i-type microcrystalline semiconductor layer are required; and that the manufacturing cost increases.
Over the past few years, to eliminate these disadvantages, the development of technologies with an improved film deposition rate for the i-type microcrystalline semiconductor layer and the development of a plasma CVD apparatus capable of deposition over a wide area, at high quality, and with good uniformity have been underway.
Recently, technology related to improving the film deposition rate of the i-type microcrystalline semiconductor layer could be realized by using a VHF (very high frequency band: 30 MHz - 300 MHz) plasma CVD apparatus with film deposition conditions of using silane gas (SiH4) diluted by a large amount of hydrogen, a high pressure, and supplying a high power. However, the current situation in the development of the plasma CVD apparatus capable of deposition over a large area, with good uniformity, and with high quality is that there are still many problems and discrepancies have developed.
By using VHF plasma CVD using parallel plate electrodes Non-Patent Document 1 discloses a technology related to a high-quality and high-speed film deposition of crystalline i-layer film for an integrated tandem thin-film silicon solar cell.
Specifically, high-quality microcrystalline Si is obtained under the test conditions of parallel plate electrode size: 10 cm diameter, raw material gas: high hydrogen-diluted SiH4, pressure: 2 - 4 Torr (133 - 532 Pa), substrate temperature: 250°C, power source frequency: 60 MHz, applied power: 2.54 W/cm2 for a 1.7 nm/s deposition rate and 3.4 W/cm2 for 2.5 nm/s.
In addition, even under the high-speed film deposition conditions of 1.7 to 2.5 nm/s, high-quality microcrystalline Si is obtained by using VHF plasma CVD at a frequency of 60 MHz.
The applied power is 2.54 W/cm2 for a film deposition rate of 1.7 nm/s and 3.4 W/cm2 for a film deposition rate of 2.5 nm/s. The need for an extremely large power means that, for example, if a simple proportional calculation is made when the substrate area is 110 cm x 140 cm (15,400 cm2), 39.1 kW is required for a film deposition rate of 1.7 nm/s and 52.4 kW for 2.5 nm/s.

Non-Patent Document 2 discloses research results on power consumption in plasma generation using parallel plate electrodes.

Specifically, the 13.56-MHz power in the parallel plate electrodes (size: 15-cm diameter, electrode gap: 5 cm) arranged in a vacuum vessel having a 30-cm diameter is applied through impedance matching boxes to conduct the N2 plasma generation test and measure the consumed amount of the applied power.

As the measurement results, approximately 52% of the power source output (300 W) was consumed between the parallel plate electrodes, and the remaining 48% was consumed elsewhere (impedance matching boxes: 12%, transmission lines: 24%, ineffective plasma generation between the electrodes and inner wall of the vacuum vessel: 12%).

The above means that approximately 52% of the power applied from the power source is consumed between the target electrodes in RF plasma CVD apparatus using parallel plate electrodes.

Non-Patent Document 3 discloses the research results about research and development of a plasma CVD apparatus that applied a uniform VHF plasma generation method over a wide area by using the ladder electrode described in Patent Document 2 to be explained later.

Specifically, Non-Patent Document 3 presents an overview of the plasma CVD apparatus used in this research and the film deposition tests. The apparatus used in the tests is a plasma CVD apparatus having a constitution that arranged a substrate heater, a ladder electrode, and a rear substrate separated at opposing positions in a vacuum vessel. The supply of VHF power to the ladder electrode (two vertical bars having the same length arranged in one plane connected by a plurality of horizontal bars having the same length therebetween) is performed from feeding points arranged on two opposite sides. In this case, the phase difference of the voltages of the powers supplied to the two sides is changed temporally, for example, is changed as a sinusoidal waveform and supplied. The output of an impedance matching box is divided into 8 parts by using a plurality of T-type axial connectors and connected to 8 feeding points. The total number of feeding points on both sides is 16 points.

In addition, the test results show that the film deposition rate of amorphous Si is 1.7 nm/s, and nonuniformity of the film is ±18% under the conditions of 1.2-m x 1.5-m electrode dimension, 1.1-m x 1.4-m substrate area, 60-MHz power source frequency, 20-mm interval between the ladder electrode and the substrate heater, 45-Pa (0.338-Torr) pressure.

Non-Patent Document 4 discloses the research results on the research and development of a plasma CVD apparatus that applied a large-area, uniform VHF plasma generation method using the ladder electrode described later in Patent Document 3 to be described later.

Specifically, Non-Patent Document 4 presents an overview of the plasma CVD apparatus used in the research and the film deposition tests. A plasma CVD apparatus having a constitution that arranged a ladder electrode and a grounded electrode separated at opposite positions in a vacuum vessel is presented as the apparatus used in the tests. The supply of VHF power to the ladder electrode (two vertical bars having the same length arranged in one plane connected by a plurality of horizontal bars having the same length therebetween) is from feeding points arranged on two opposite sides. In this case, the phase difference of the voltages of the powers supplied to the two sides is changed to a sinusoidal wave shape and supplied. An 8-branch power divider is arranged between the impedance matching box and a plurality of feeding points arranged on one side.

The test results show that the film deposition rate of amorphous Si is 0.5 nm/s and the nonuniformity of the film is ±15% under the conditions of electrode dimensions of 1.25 m x 1.55 m (bar diameter: 10 mm), a 1.1-m x 1.4-m substrate area, a 60-MHz power source frequency, a 20-kHz sinusoidal wave phase difference of the voltage, a 20-mm interval between the ladder electrode and the substrate heater, and a 45-Pa (0.338-Torr) pressure.

Patent Document 1 discloses an invention related to a VHF plasma CVD apparatus using the ladder electrode and the method thereof.

Specifically, the technology described in Patent Document 1 is a manufacturing method of a photoelectric converter using a plasma CVD apparatus in which the discharge electrode and the grounded electrode are arranged to be opposite in a chamber and comprises (A) a step for arranging the substrate deposited with a p-layer film on the grounded electrode to be opposite to the discharge electrode, (B) a step for setting the distance between the substrate and the discharge electrode to 8 mm or less, (C) a step for heating the substrate to 180 - 220°C by a heater installed in the grounded electrode, (D) a step for supplying the raw material gas to the interior of the chamber, (E) a step for setting the pressure in the chamber to 600 Pa - 2,000 Pa, (F) a step for depositing the power generation layer on the substrate by supplying ultrahigh frequency power to the discharge electrode to create plasma from the raw material gas, and (G) a step for depositing an n-layer film on the power generation layer.

In addition, the technology described in Patent Document 1 features a power density of the ultrahigh frequency power of at least 3.0 kW/m2 in step (F).

In addition, the technology described in Patent Document 1 features a frequency of the ultrahigh frequency power of at least 40 MHz in step (F).

In addition, under the conditions where the film deposition rate is 3 to 3.5 nm/s and the conversion efficiency is 12 to 12.5%, the data shows a power density of 5 to 6 kW/m2 at a pressure of 800 Pa.

Patent Document 2 discloses a method for generating uniform VHF plasma over a large area.

Specifically, the technology described in Patent Document 2 is a feed method to the discharge electrode in which a single substrate to be treated held in the mounting electrode and a single discharge electrode are arranged separated and opposite in a discharge vessel, and an essentially uniform discharge state is generated in a wide range between the discharge electrode and the substrate to be treated. When power is fed through a plurality of feeding points to the discharge electrode, by temporally changing the difference between the phase of a voltage waveform of the high-frequency power supplied to one feeding point and the phase of the voltage waveform of the high-frequency power supplied to at least one of the other feeding points, the voltage distribution created in the discharge electrode is changed, and the resulting average per unit time or the integral value per unit time of the voltage distribution essentially becomes uniform, and the generation of standing waves in the voltage distribution of the discharge electrode is suppressed.

In addition, the technology described in Patent Document 2 uses a ladder electrode as the discharge electrode.

In addition, the frequency of the high-frequency wave used is in the range from 30 to 800 MHz.

Patent Document 3 discloses a apparatus that uses a ladder electrode to generate uniform plasma over a large area.

Specifically, the technology described in Patent Document 3 has the constitution of a ladder discharge electrode for plasma generation in a plasma chemical vapour deposition apparatus, and is characterised by having a cycle for feeding a high-frequency wave having a first identical frequency to the feeding parts at both ends of the ladder discharge electrode and a cycle for feeding a high-frequency wave having a second different frequency, and alternately switching the cycles to feed the power, and adding cross bars in the direction perpendicular to the axial direction of the discharge electrode to create a uniform plasma that is generated by varying the standing waveform.

In addition, the technology described in Patent Document 3 has the constitution for the ladder discharge electrode for plasma generation in a plasma chemical vapour deposition apparatus and is characterised by having a cycle for feeding a high-frequency wave having a first identical frequency to the feeding parts at both ends of the ladder discharge electrode and a cycle for feeding a high-frequency wave having a second different frequency, and alternately switching the cycles to feed the power, and adding cross bars in the direction perpendicular to the axial direction of the discharge electrode, and reducing the diameter of the ladder discharge electrode in the range that increases the standing wave wavelength to create a uniform generated plasma.

The technology described in Patent Document 3 has the constitution for a ladder discharge electrode for plasma generation in a plasma CVD apparatus and is characterised by having a cycle for feeding a high-frequency wave having a first identical frequency to the feeding parts at both ends of the ladder discharge electrode and a cycle for feeding a high-frequency wave having a second different frequency, and alternately switching the cycles to feed the power, and dividing the discharge electrode into a plurality of parts in the direction perpendicular to the axial direction to balance the power in the horizontal direction of the discharge electrode to reduce the bias of the plasma density.

Patent Document 4 discloses a method capable of generating uniform VHF plasma over a large area by alternately generating in time two standing waves between a pair of electrodes.

Specifically, the technology described in Patent Document 4 is a plasma surface treatment method that is comprised of a vacuum vessel that is provided with an exhaust system and has a substrate set therein; a gas supply system for supplying the gas for electrical discharge in the vacuum vessel; a pair of electrodes comprised of 1st and 2nd electrodes for generating plasma; a power supply system comprised of a 1st high-frequency power source with two outputs that can optionally pulse-modulate and optionally set the phase difference of the two output voltages, 1st and 2nd impedance matching boxes connected to the two output terminals of the 1st high-frequency power source, a 2nd high-frequency power source with two outputs that can optionally pulse-modulate synchronized to the pulse-modulated signal of the 1st high-frequency power source and can optionally set the phase difference of the two output voltages, and 3rd and 4th impedance matching boxes connected to the two output terminals of the 2nd high-frequency power source; and uses the generated plasma to treat the surface of a substrate. The plasma surface treatment method sets the distance of the antinode positions of the 1st standing wave generated between the pair of electrodes by the two outputs of the 1st high-frequency power source and the antinode positions of the 2nd standing wave generated between the pair of electrodes from the two outputs of the 2nd high-frequency power source to a quarter of the wavelength $\lambda$, i.e., $\lambda/4$, of the power used.

In addition, the technology described in Patent Document 4 is a plasma surface treatment method that provides a vacuum vessel that is provided with an exhaust system and has a substrate set therein; a discharge gas supply system that supplies the gas for electrical discharge in the vacuum vessel; a pair of electrodes comprised of 1st and 2nd electrodes for generating plasma; a power supply system comprised of a 1st high-frequency power source with two outputs that can optionally pulse-modulate and can optionally set the phase difference of the two outputs, 1st and 2nd impedance matching boxes connected to the two outputs of the 1st high-frequency power source, a 2nd high-frequency power source with two outputs that can optionally pulse-modulate synchronized to the pulse-modulated signal of the 1st high-frequency power source and can optionally set the phase difference of the two output voltages, and a 3rd and a 4th impedance matching box connected to the two output terminals of the 2nd high-frequency power source; and uses the generated plasma to treat the surface of the substrate. The plasma surface treatment method is characterised by comprising a first step for determining the relationship between the phase difference of the two outputs of the 1st high-frequency power source and the position of the maximum film thickness of the Si film having a sinusoidal film thickness distribution deposited on the substrate surface, a second step for determining the relationship between the phase difference of the two outputs of the 2nd high-frequency power source and the position of the maximum film thickness of the Si film having a sinusoidal film thickness distribution deposited on the substrate surface, and a third step for depositing the target Si film on the substrate by setting the phase difference of the two outputs of the 1st and the 2nd high-frequency power sources based on the relationship between the phase difference of the two outputs of the 1st and the 2nd high-frequency power sources and the position of the maximum film thickness determined in steps 1 and 2, respectively. If the 1st standing wave and the 2nd standing wave are generated between the pair of electrodes and the interval between the antinodes of the two is a quarter of the wavelength $\lambda$ of the power used, the intensity I(x) of the power between the pair of electrodes is as follows and becomes uniform (constant) independent of the frequency.

$$I(x) = \cos^2(2\pi x/\lambda + \Delta\theta /2) + \sin^2(2\pi x/\lambda + \Delta\theta /2)$$

where x is the distance in the transmission direction of the supplied power, $\lambda$ is the wavelength of the power used, and $\Delta\theta$ is the initial phase difference at the feeding points.

Patent Document 5 discloses a apparatus and a method related to the technology that sets a balanced-to-unbalanced converter between the impedance matching box in the power supply circuit and the feeding points on the electrode.

Specifically, the technology described in Patent Document 5 is a balanced transmission circuit used in a plasma surface treatment apparatus that uses the generated plasma to treat the surface of the substrate, and comprises a vacuum vessel provided with an exhaust system; a discharge gas supply system for supplying the gas for electrical discharge in the vacuum vessel; electrodes for plasma generation; a power supply system comprised of high-frequency power sources, impedance matching boxes, and balanced-to-unbalanced converters; and a substrate mounting means for positioning the substrate to be plasma treated. The balanced transmission circuit is characterised by a constitution in which at least both ends of the outer conductors of two coaxial cables having roughly equal lengths are short-circuited, one end of the core line of the two coaxial cables becomes the input, and the other end of the core line becomes the output.

In addition, the technology described in Patent Document 5 is a balanced transmission circuit used in a plasma surface treatment apparatus that uses the generated plasma to treat the surface of the substrate and comprises a vacuum vessel provided with an exhaust system; a discharge gas supply system for supplying the gas for electrical discharge in the vacuum vessel; electrodes for plasma generation; a power supply system comprised of high-frequency power sources, impedance matching boxes, and balanced-to-unbalanced converters; and a substrate mounting means for positioning the substrate to be plasma-treated; and the balanced transmission circuit is characterised by a constitution in which at least both ends of the outer conductors of two coaxial cables having roughly equal lengths are short-circuited by another conductor, one end of the core line of the two coaxial cables becomes the input, and the other end of the core line becomes the output.

In addition, the technology described in Patent Document 5 is a plasma surface treatment apparatus that comprises a vacuum vessel provided with an exhaust system; a discharge gas supply system for supplying the gas for electrical discharge in the vacuum vessel; a pair of electrodes comprised of 1st and 2nd electrodes for generating plasma; a power supply system comprised of high-frequency power sources, impedance matching boxes, and balanced-to-unbalanced converters; and a substrate mounting means for positioning the substrate to be plasma treated; and uses the generated plasma to treat the surface of the substrate. The plasma surface treatment apparatus is characterised by providing a plurality of openings for the pair of electrodes, using a balanced transmission circuit having the above constitution, and connecting the output circuit of the balanced-to-unbalanced converter of the constituent parts of the power supply system to the power feeding points of the pair of electrodes.

In addition, the technology described in Patent Document 5 is a plasma surface treatment apparatus that uses the generated plasma to process the substrate surface and comprises a vacuum vessel provided with an exhaust system, a discharge gas supply system for supplying the gas for electrical discharge in the vacuum vessel; a pair of electrodes comprised of 1st and 2nd electrodes for generating plasma; power supply points for the pair of electrodes; a power supply system comprised of high-frequency power sources, impedance matching boxes, and balanced-to-unbalanced converters; a substrate mounting means for positioning the substrate to be plasma-treated; and a balanced transmission circuit having the abovementioned constitution. The plasma surface treatment apparatus is characterised by a apparatus structure of the power supply circuit for supplying power to the pair of electrodes from the power supply system that sequentially arranges high-frequency power sources, impedance matching boxes, balanced-to-unbalanced converters, balanced transmission lines, and power feeding points from the upstream side to the downstream side in the power flow.

In addition, Patent Document 5 indicates that the conventional plasma CVD apparatus using the parallel plate electrodes and the plasma CVD apparatus using the ladder electrode generate leakage current in the power feeding part to the electrode used in the apparatus, generate abnormal discharge or arcing, and generate plasma at locations outside of the pair of electrodes, and has difficulty uniformly depositing film.

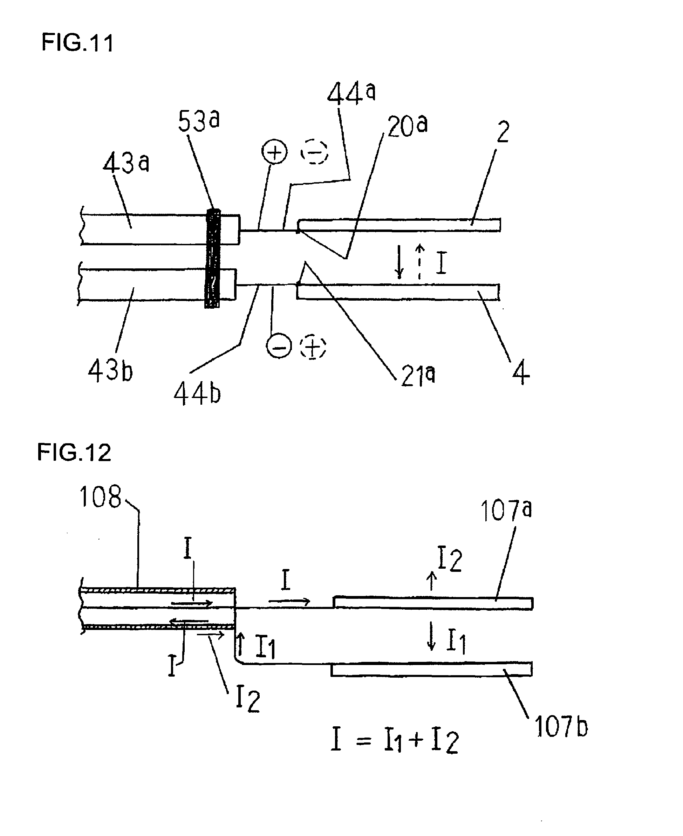

Specifically, in the conventional plasma CVD apparatus, the connector of the coaxial cable for power supply and the electrode connects lines having mutually different structures and generates leakage current in the connector. The coaxial cable is a transmission method in which the inner conductor (core line) and the inner surface of the outer conductor are the outgoing path and return path, respectively, and the pair of electrodes is constructed to correspond to two parallel wires. The concept of the leakage current described here is as shown in Figure 12. In this drawing, current I flowing from the core line of coaxial cable 108 to the pair of electrodes 107a, 107b side is divided into current I1 flowing back between the pair of electrodes and current I2 that does not flow between the pair of electrodes but flows elsewhere. Current I2 is the leakage current. The currents shown in Figure 12 are illustrated conceptually for some instance and is an alternating current phenomenon. Naturally, the magnitude and the direction of the illustrated currents change over time.

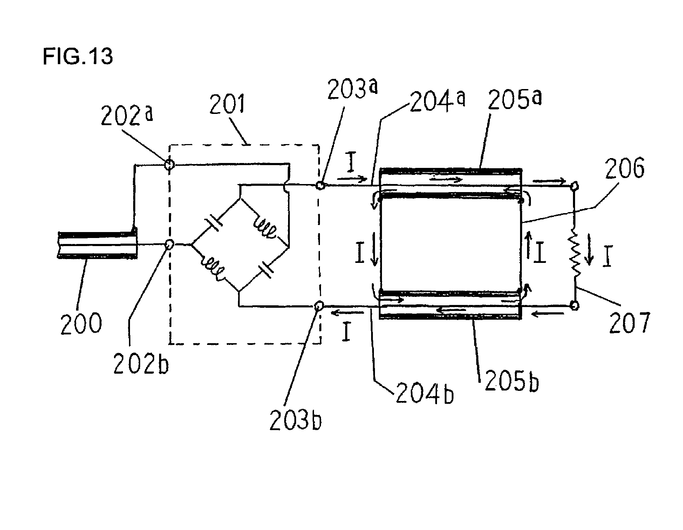

To prevent abnormal discharge or arcing caused by the leakage current, as shown in Figure 13, a apparatus that combines balanced-to-unbalanced converter 201 and balanced transmission line constructed from two coaxial cables 205a, 205b is used. In Figure 13, the core line and the outer conductor of the end of power transmission coaxial cable 200 are connected to input terminals 202a, 202b of balanced-to-unbalanced converter 201, and output terminals 203a, 203b thereof are connected to the core lines at the inputs of the balanced transmission lines constructed from the two coaxial cables 205a, 205b. The outer conductors of both ends of the two coaxial cables 205a, 205b are short circuited. The core line of the output of the balanced transmission line is connected to addition 207.

The balanced transmission line short circuits the outer conductors of the two coaxial cables 205a, 205b to form a closed loop, and there is no current leakage. As a result, the output current I of the balanced-to-unbalanced converter 201 can be supplied to addition 207 without leaking.

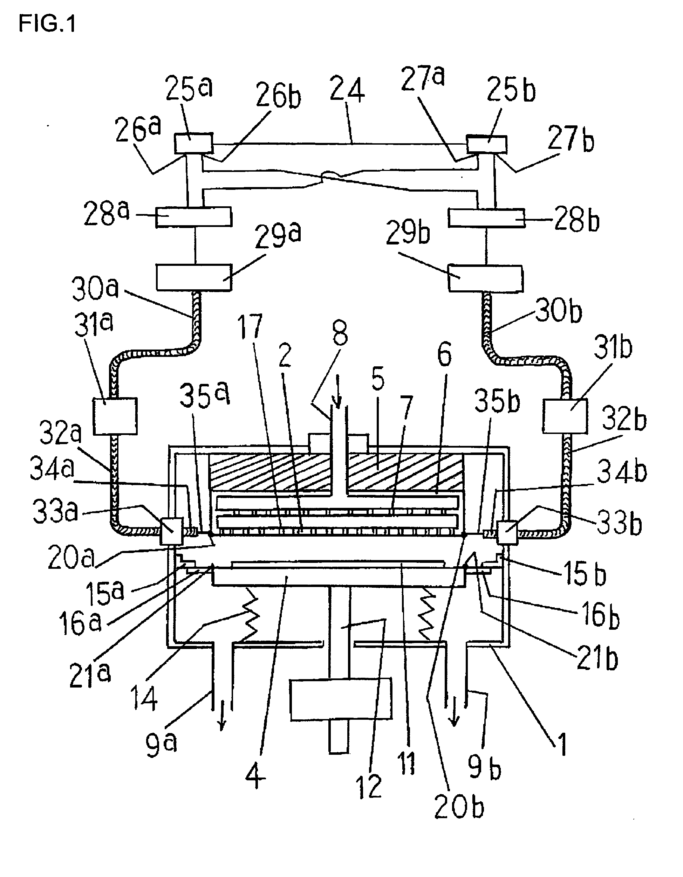

Patent Document 1
JP-A-2006-216921 (Figure 6, Figure 9, Figure 10)
Patent Document 2
Japanese Patent No. 3316490 (Figs. 1 - 3, Figure 6, Figure 7)
Patent Document 3
Japanese Patent No. 3611309 (Fig. 1, Fig. 2, Fig. 3, Fig. 4)
Patent Document 4
P-A-H2005-123203 (Figs. 1 - 4, Fig. 8, Fig. 9)
Patent Document 5
Japanese Patent No. 3590955 (Figs. 1-8, Figs. 15 - 17)

Non-Patent Document 1
M. Kondo, M. Fukawa, L. Guo, A. Matsuda, "High rate growth of microcrystalline silicon at low temperatures", Journal of Non-Crystalline Solids, 266-269 (2000), 84-89.
Non-Patent Document 2
J.A. Baggerman, R.J. Visser, and E.J.H. Collart, "Power dissipation measurements in a low-pressure N2 radio-frequency discharge", J. Appl. Phys., Vol. 76, No. 2, 15 July 1994, 738-746.
Non-Patent Document 3
H. Takatsuka, Y. Yamauchi, K. Kawamura, H. Mashima, Y. Takeuchi, "World's largest amorphous silicon photovoltaic module", Thin Solid Films, 506-507 (2006), 13-16.
Non-Patent Document 4
K. Kawamura, H. Mashima, Y. Takeuchi, A. Takano, M. Noda, Y. Yonekura, H. Takatuka, "Development of large-area a-S:H films deposition using controlled VHF plasma", Thin Solid Films, 506-507 (2006), 22-26.

DISCLOSURE OF THE INVENTION

PROBLEMS TO BE SOLVED BY THE INVENTION

In addition to the problems indicated in the above Non-Patent Documents 1 to 4 and Patent Documents 1 to 5 as the problems related to the abovementioned plasma CVD apparatus used in the manufacture of integrated tandem thin-film silicon solar cells, the present inventors have discovered the following problems unique to the manufacturing field of the integrated tandem thin-film silicon solar cell described above.

Specifically, in the manufacturing field of the integrated tandem thin-film silicon solar cell described above, a plasma CVD apparatus and method capable of satisfying requirement items (a) to (e) below are sought, but an apparatus and technology meeting the items other than (a) have not been established.

The discovery of a plasma CVD apparatus and a method related to items (b) to (e) is a major issue in the design for manufacturing with good reproducibility, manufacturing with good yield, and lower manufacturing costs related to the manufacture of integrated tandem thin-film silicon solar cells.

The items required in the manufacturing field of the abovementioned integrated tandem thin-film silicon solar cell are as follows.

(a) High-speed film deposition is possible, and a high-quality crystalline i-layer film can be formed. For example, a deposition rate of at least 2 nm/s and Raman spectral characteristics of the deposited film are satisfactory.
(b) In a large-area substrate having a substrate area of at least 1 m x 1 m, a high-quality i-layer film having good uniformity can be formed at a high speed. For example, the substrate area is 1.1 m x 1.4 m, the film deposition rate is at least 2 nm/s, and the nonuniformity of the film thickness is less than $\pm10\%$ (when the nonuniformity is above approximately $\pm10\%$, ensuring precision of the film processing by laser becomes difficult in a laser processing step in the manufacturing process of integrated tandem thin-film silicon solar cells, and ensuring the battery performance and yield become difficult).
(c) Abnormal discharges (arcing) are not generated in the vicinity of the power feeding part(s).
(d) The fed power is effectively used in forming the high-quality crystalline i-layer film. Specifically, plasma is generated only between the grounded electrode and the ungrounded electrode arranged on a substrate. Plasma cannot be generated outside of the pair of electrodes.
(e) The power consumed in the transmission line that supplies the feed power is small.

When power losses caused by abnormal discharges (arcing) and plasma generation outside of the pair of electrodes and power losses in the power transmission line are large, the running costs in the manufacturing line of integrated tandem thin-film silicon solar cells increase, and reduction of the product manufacturing costs becomes difficult.

The problems in a plasma CVD apparatus using flat plate electrodes, which is a typical conventional plasma CVD apparatus, and a plasma CVD apparatus using a ladder-type electrode are explained below.

First, an overview of the constitution and the technology of the plasma CVD apparatus using parallel flat plate (termed as "parallel plate" herein after) electrodes, which is a typical plasma CVD apparatus in the thin-film silicon solar cell field, is presented as in, for example, Non-Patent Documents 1 and 2.

In this apparatus, an ungrounded plate electrode and a plate electrode connected to ground are positioned opposing each other. A raw material gas therebetween is supplied, and power is supplied to generate plasma. A silicon film is deposited beforehand on a substrate arranged on the grounded electrode.

In this case, the feeding points that connect the ungrounded electrode and the core lines of the coaxial cables supplying power to the electrode are arranged on the rear surface of the ungrounded electrode. The rear surface is a surface disposed rear as viewed from the side of plasma generated between the ungrounded electrode and the grounded electrode of the two surfaces of the ungrounded electrode.

The power wave propagated as an electromagnetic wave (wave motion) from the feeding point is propagated in the space between the ungrounded electrode and the wall of the vacuum vessel (or in case a ground shield is installed, the space between the ungrounded electrode and ground shield) from one point on the rear surface of the ungrounded electrode and reaches (a space) between the electrodes. Then plasma is generated between the electrodes.

When the frequency of the power used is in the 10 MHz to 30 MHz band and the VHF band (30 MHz - 300 MHz), a plasma CVD apparatus using parallel flat plate electrodes having the abovementioned structure has the problems of power losses and the generation of unneeded plasma not between the electrodes, standing waves which are difficult to control generated between the electrodes, and difficulty in generating uniform plasma. Therefore, a VHF plasma CVD apparatus having a target of a large-area substrate with a 1-m x 1-m substrate area is not prought into practical use.

Non-Patent Document 1 discloses that, when a high-quality, high-speed film deposition of a crystalline i-layer film for an integrated tandem thin-film silicon solar cell is performed, the applied power is 2.54 W/cm2 for a deposition rate of 1.7 nm/s and is 3.4 W/cm2 for 2.5 nm/s.

For example, if a simple proportional calculation be performed for a substrate area of 110 cm x 140 cm (15,400 cm2), the required numerical values will amount to 39.1 kW for a deposition rate of 1.7 nm/s and 52.4 kW for 2.5 nm/s.

A VHF power supply apparatus has a output of approximately 5 to 10 kW. The purchase price of the apparatus is expensive ranging from 80 million yen to 100 million yen. If the output is the above 39.1 kW or 52.4 kW, a very expensive apparatus costing 400 million yen to 500 million yen results.

In the actual manufacturing line, the introduction of the above very expensive apparatus causes a large increase in the product cost. Therefore, the abovementioned plasma CVD apparatus using parallel flat plate electrodes and the abovementioned film deposition conditions are difficult to adopt.

In addition, if the case which selects the conditions of a substrate area of 110 cm x 140 cm, 2.5 nm/s, and 52/4 kW be presumably considered for the manufacturing line of the crystalline i-layer film for an integrated tandem thin-film silicon solar cell, amounts of power consumption and power fees as described below are required.

When the operating rate of the above manufacturing line is 85%, the amount of power consumed annually in only one room of a film deposition room of crystalline i-layer film becomes 52.4 kW x 365 days x 24 hours/day x 0.85 = 390,170.4 kWh. If the electricity rate is 20 yen per 1 kWh, approximately 7,800,000 yen results (even if 15 yen per 1 kWh, approximately 5,850,000 yen results).

In an actual manufacturing line, an enormous electricity charge as described above entails increase in the product cost. Therefore, the above plasma CVD apparatus using parallel flat plate electrodes and the above film deposition conditions are difficult to adopt.

According to the research results presented in Non-Patent Document 2, approximately 52% of the power source output is consumed between the parallel flat plate electrodes. The remaining 48% is consumed at other locations (12% in impedance matching boxes, 24% in transmission lines, 12% in ineffective plasma generation between the electrodes and the inner wall of the vacuum vessel).

This means that in the application to the manufacture of a power generation film for a solar cell, the effective consumption in the manufacture of the power generation film is approximately 52%, and approximately 48% is wasted as useless (or harmful) power.

In the research results of Non-Patent Document 2, if the power consumption described in Non-Patent Document 1 is considered, this means that the amount of power consumed annually which is wasted as useless (or harmful power) is 48% of 52.4 kW x 365 days x 24 hours/day x 0.85 = 390,170.4 kWh, namely, 187,282 kWh, in only one room of a film deposition room for crystalline i-layer film for the above manufacturing line.

In the conventional plasma CVD apparatus using parallel plate electrodes as described above, the problems are power losses and the generation of unneeded plasma outside of the electrodes.

Even if errors are included in specific numerical values in Non-Patent Documents 1 and 2, the existence of the power loss problem cannot be denied.

Next, in a plasma CVD apparatus using a ladder electrode, the problems are a non-uniform thickness distribution of the semiconductor film to be deposited and power losses as will be described below.

In this apparatus, for example, as described in Non-Patent Document 3, Non-Patent Document 4, Patent Document 1, Patent Document 2, and Patent Document 3, the substrate heater combined with the grounded electrode in the vacuum vessel, the ungrounded ladder electrode, and the rear plate arranged on the rear side (as viewed from the substrate heater side) of the ladder electrode are arranged apart at opposing positions. A ladder electrode positions two vertical bars having the same length in a plane and a plurality of horizontal bars having the same length connecting therebetween. A raw material gas produces plasma both when ejected from the ladder electrode or when ejected from a rear plate. A silicon film is deposited on a substrate positioned beforehand on the substrate heater.

The feeding points connecting the core lines of the coaxial cables supplying power to the electrode and the ungrounded electrode are arranged on the outer periphery of the ladder electrode and at opposite positions.

The power wave transmitted as an electromagnetic wave (wave motion) from the feeding point is transmitted in a space between the ladder electrode and the substrate heater, and in a space between the ladder electrode and the rear plate, and generates plasma in each space. Specifically, a feature is that plasma is generated on both surfaces of the ladder electrode in this apparatus.

In this case, the voltage phase difference of the power supplied from opposite feeding points is changed temporally, for example, changed as a sinusoidal waveform having a 1 kHz frequency and supplied. The result is that standing waves that oscillate at a speed of 1 kHz, for example, are generated between the opposing feeding points described above in the space between the ladder electrode and the substrate heater, and the space between the ladder electrode and the rear plate.

Because of the effects of the standing waves moving as described above in this apparatus and method, a uniform VHF plasma can be generated for a target large-area substrate having a substrate area of at least approximately 1 m x 1 m.

According to Non-Patent Document 3, under the conditions of 1.2-m x 1.5-m electrode dimensions, 1.1-m x 1.4-m substrate area, 60-MHz power source frequency, 20-mm interval between the ladder electrode and the substrate heater, and a 45-Pa (0.338-Torr) pressure, the film deposition rate of amorphous Si is 1.7 nm/s, and the film non-uniformity of $\pm 18\%$ is exhibited.

According to Non-Patent Document 4, under the conditions of 1.25-m x 1.55-m electrode dimensions (bar diameter: 10 mm), 1.1-m x 1.4-m substrate area, 60-MHz power source frequency, 20-kHz sinusoidal wave for the voltage phase difference, 20-mm interval between the ladder electrode and the substrate heater, and a 45-Pa (0.338-Torr) pressure, a film deposition rate of amorphous Si is 0.5 nm/s, and a film non-uniformity of $\pm 15\%$ is exhibited.

The problems of power losses related to the plasma CVD apparatus using the ladder electrode and the generation of unneeded plasma generated outside of the electrode gap are not described in Non-Patent Document 3, Non-Patent Document 4, Patent Document 1, Patent Document 2, and Patent Document 3.

However, if the structures of the apparatuses described in Non-Patent Document 3, Non-Patent Document 4, Patent Document 1, Patent Document 2, and Patent Document 3 are examined, as described below, the existence of problems of the power losses and the generation of unneeded plasma generated outside of the electrode gap is easily pointed out.

First, there is a problem that the wasteful power consumption is caused by the electrodes and the power feed method. The plasma generation apparatus using the ladder electrode is a two-surface discharge method that uses plasma generated on both surfaces of the ladder electrode, but in practice, a substrate is not set up on both surfaces, and the discharge of one surface is used. Thus, the problem is the discharge of the other surface is an ineffective discharge, i.e., unneeded plasma generation. As a result is is considered that approximately 30% to 40% of all of the power supplied from the feeding points is consumed wastefully. That is, there is the power loss problem of wasteful plasma generation. In the abovementioned two-surface discharge method, namely, the method setting a substrate on both sides, in practice, the control of the stable generation of plasma on two surfaces is difficult, and appears to be rarely adopted in the parallel plate plasma CVD apparatus, too, not only with respect to those using the ladder electrode.

Second, a problem caused by the first problem described above is generation of powders and particles caused by the generation of unneeded plasma. This problem is a serious problem which induces problems such as the drop in the equipment operating rate of the manufacturing line and a reduced performance of the power generation film to be manufactured.

Third, when the target is a large-area substrate having a substrate area of at least approximately 1 m x 1 m, a plurality of feeding points is arranged to generate uniform VHF plasma. A power distribution circuit using a plurality of T-shaped axial connectors is used in the power transmission line for supplying the power to the plurality of feeding points that are provided. For example, in the Non-Patent Document 3, seven T-shaped coaxial cables are used to form 8 branches to feed power to one end of the ladder electrode. This branching means generates power losses at the connecting parts of the coaxial cables and the T-shaped coaxial connectors.

Generally, in the power transmission in the VHF region, power losses of 2 to 3% at the connecting parts are known. Assume a loss of 3%, the power loss caused by the T-shape coaxial connectors becomes 3% x 7 connectors x 2 (both ends) = 42%. For an actual manufacturing line, this numerical value becomes extremely large counted as a problem.

In Non-Patent Document 4, a power divider is used, but, generally, when the power divider has a large number of branches, the power loss internal to the power divider is 10 to 15%, which is a number that offers a problem.

Next, the technology described in Patent Document 4 generates a uniform plasma between a pair of electrodes by using a 1st high-frequency power source with two outputs and a pulse modulation scheme capable of optionally setting the phase of the outputs, and a 2nd high-frequency power source with two outputs and a pulse modulation scheme capable of optionally setting the phase of the outputs that transmits in a time band different from a transmission time band of the output of the 1st high-frequency power source to generate a 1st standing wave and a 2nd standing wave, respectively, and setting the antinode positions of the two standing waves to a quarter of the wavelength.

Specifically, let the wavelength of the power used be $\lambda$, the transmission direction of the power be x, and the phase difference be $\Delta\theta$, then the intensities of the 1st standing wave and the 2nd standing wave generated at the pair of electrodes are:

$$\text{1st standing wave} = \cos^2\{2\pi x/\lambda + \Delta\theta/2\}$$

$$\text{1st [\textit{sic}, 2nd] standing wave} = \sin^2\{2\pi x/\lambda + \Delta\theta/2\}$$

$$\text{1st standing wave} + \text{2nd standing wave} = \cos^2\{2\pi x/\lambda + \Delta\theta/2\} + \sin^2\{2\pi x/\lambda + \Delta\theta/2\} = 1$$

Generally, the power intensity and the plasma intensity have a proportional relationship. The plasma intensity I(x) is as follows.

$$I(x) = \cos^2\{2\pi x/\lambda + \Delta\theta/2\} + \sin^2\{2\pi x/\lambda + \Delta\theta/2\} = 1,$$

which means that a uniform plasma can be generated independent of the wavelength $\lambda$ of the power used.

However, the conditions that should be satisfied in the high-frequency plasma CVD apparatus and the method determined in the manufacturing field of integrated tandem thin-film silicon solar cells do not describe the conditions (d) and (e) as follows:

(d) The supplied power is effectively used in forming the high-quality crystalline i-layer film. Specifically, plasma is generated only between the grounded electrode that provides the substrate and the ungrounded electrode. Outside of the pair of electrodes, harmful plasma cannot be generated, and abnormal discharges (arcing) are not generated in the vicinity of the connecting parts of the power supply circuit and the electrodes, and
(e) The power consumed in the transmission lines that supply the feed power is small.

In other words, the technology described in Patent Document 4 can be said to be the problem of power losses caused by leakage current generated at the connecting parts (interfaces) of the ends of the coaxial cables and the feeding points.
Next, in the technology described in Patent Document 5, a balanced-to-unbalanced converter is arranged between the impedance matching boxes in the power supply circuit and the feeding points on the electrodes; the balanced-to-unbalanced converter and the feeding points of the pair of electrodes are short-circuited on at least both ends of the outer conductors of the two coaxial cables having the same length, one end of each core line of the two coaxial cables is the input part and other end of each core line is the output part; and leakage current and abnormal discharges in the power feed parts, which are problems in the conventional technologies, can be suppressed. The result is that the power loss problem can be solved effectively.
In addition, the uniformity of large-area plasma is described as being effective because abnormal discharges in the power feed parts can be suppressed.
However, the application of larger area and uniformity of the plasma is difficult in practice by only using the technology described in Patent Document 5. The result is that the application is limited to apparatuses which suppress abnormal discharges in the power feed parts.
Among the conditions that should be satisfied by the high-frequency plasma CVD apparatus and the method sought in the abovementioned manufacturing field of the integrated tandem thin-film silicon solar cell, it can be said that there exists the problem with respect to:

(b) In a large-area substrate having a substrate area of at least 1 m x 1 m, a high-quality i-layer film having good uniformity can be formed at high speed.

As described above, it is impossible to satisfy all of the above items (a) to (e) according to the conventional technology.
In other words, specific technical problems of the conventional high-frequency plasma CVD technology field are: 1. to create a technology enabling to suppress the generation of abnormal discharges and to generate plasma only between the pair of electrodes in a larger area and with uniformity, and 2. to create a technology enabling to suppress power losses in the power transmission lines.
It is an objective of the present invention to provide a high-frequency plasma CVD apparatus and a plasma CVD method in order to enable a faster speed, a larger area, and better uniformity of the plasma surface treatment, and to create the idea of a technology that enables to generate plasma only between a pair of electrodes, suppress generation of abnormal discharges and losses of the power being fed, and implement that idea.

MEANS TO SOLVE THE PROBLEMS

Below, the reference numbers and symbols used in preferred modes for implementing the present invention are used to explain the means for solving the problems. These reference numbers and symbols are added in parentheses to clarify the correspondence of the descriptions in the claims to the preferred modes for implementing the invention. However, those reference numbers and symbols should not be used to interpret the technical scope of the invention set forth in the claims.
A high-frequency plasma CVD apparatus of a first invention in the present application that forms a thin film on a surface of substrate (11) arranged in a vacuum vessel (1) by using plasma is characterised by having high-frequency power source means (25a, 25b, 28a, 28b, 29a, 29b, 30a, 30b, 31a, 31b, 32a, 32b, 33a, 33b, 34a, 34b) that sets the interval between 1st feeding point (20a) arranged at the end of electrode (2) and 2nd feeding point (20b) arranged at a position opposite the 1st feeding point in transmission of power wave is set to an integer n times one half of a wavelength $\lambda$, i.e., $n\lambda/2$, for which wavelength reduction rate of the power used is considered, and alternately generates in time a 1st standing wave whose antinode positions matched positions of the 1st and 2nd feeding points (20a), (20b) and a 2nd standing wave whose node positions matched positions of the 1st and 2nd feeding points (20a), (20b).
The wavelength $\lambda$ of the power used for which the wavelength reduction rate is considered is the wavelength

$\lambda$ when the power is transmitted between (across) the pair of electrodes (2, 4) generating the plasma. Generally, the wavelength $\lambda$ of the power used considering the wavelength reduction rate is shorter than the wavelength $\lambda_o$ when the power used is transmitted in vacuum. In addition, usually for the plasma of silane gas, the ratio of wavelength $\lambda$ to wavelength $\lambda_o$, that is, $\lambda/\lambda_o$, is $\lambda/\lambda_o$ = approximately 0.6 when the pressure is approximately 40 to 530 Pa (0.3 to 4 Torr), and the plasma density is approximately 4 to 6 x $10^9/cm^3$. When the pressure is 530 to 1333 Pa (4 to 10 Torr), and the plasma density is approximately 6 to 10 x $10^9/cm^3$, $\lambda/\lambda_o$ = approximately 0.5 to 0.55.

A high-frequency plasma CVD apparatus of a second invention relating to the present application that forms a thin film on the surface of substrate (11) arranged in a vacuum vessel (1) by using plasma is characterised by: having high-frequency power source means (25a, 25b, 28a, 28b, 29a, 29b, 30a, 30b, 31a, 31b, 32a, 32b, 33a, 33b, 34a, 34b) that sets the interval between 1st feeding point (20a) arranged at the end of electrode (2) and 2nd feeding point (20b) arranged at a position opposite the 1st feeding point in the transmission of the power wave to an integer n times one half of the wavelength $\lambda$, i.e., $n\lambda/2$, for which the wavelength reduction rate of the power used is considered, and alternately generating in time a 1st standing wave in which antinode positions matched the positions of the 1st and 2nd feeding points (20a), (20b) and a 2nd standing wave in which node positions matched the positions of the 1st and 2nd feeding points; and having balanced-to-unbalanced converters (40a, 41a, 41b, 43a, 43b, 40b, 46a, 46b, 48a, 48b) for converting an unbalanced power transmission line to a balanced power transmission line.

A high-frequency plasma CVD apparatus of a third invention relating to the present application is characterised by: comprising a vacuum vessel (1) that is provided with an exhaust system and has a substrate (11) set therein; a raw material gas supply system (6), (8) that supplies raw material gas to the interior of the vacuum vessel; a pair of electrodes formed from ungrounded electrode (2) and grounded electrode (4) for forming plasma; 2-output high-frequency power source (25a), (25b), (28a), (28b), (29a), (29b) capable of alternately generating in time two standing waves between the pair of electrodes and setting interval between antinode positions of one of the two standing waves and antinode positions of the other to a quarter of the wavelength $\lambda$, namely, $\lambda/4$, of the power used for which the wavelength reduction rate is considered; 1st and 2nd impedance matching boxes (31a), (31b) that match the impedances on the output sides of the 2-output high-frequency power source; 1st and 2nd coaxial cables (32a), (32b) for transmitting outputs of 1st and 2nd impedance matching boxes to each electrode; 1st and 2nd feeding points (20a), (20b) for connecting to the 1st and the 2nd coaxial cables, respectively, and setting in positions mutually opposite at the ends of an ungrounded electrode; and by setting the distance between the 1st and the 2nd feeding points (20a), (20b) to an integer n times one half of the wavelength $\lambda$, i.e., $n\lambda/2$, of the power used for which the wavelength reduction rate is considered.

A high-frequency plasma CVD apparatus of a fourth invention relating to the present application is characterised by being provided with:

a vacuum vessel (1) that is provided with an exhaust system and adapted to set a substrate (11) therein;
a raw material gas supply system (6), (8) that supplies raw material gas to the interior of the vacuum vessel;
a pair of electrodes formed of ungrounded electrode (2) and grounded electrode (4) for generating plasma;
a 1st high-frequency transmitter (25a) with two outputs that can optionally pulse-modulate and can optionally set the phase difference of voltages at two outputs;
a 2nd high-frequency transmitter (25b) with two outputs that transmits a pulse-modulated sinusoidal wave in a different time band than the pulse-modulate sinusoidal wave that is output from the 1st high-frequency transmitter, and can optionally set the phase difference of the voltages at the two outputs;
a 1st signal coupler (28a) that couples one signal of the two outputs of the 1st high-frequency transmitter and one signal of the two outputs of the 2nd high-frequency transmitter;
a 2nd signal coupler (28b) that couples the other signal of the two outputs of the 1st high-frequency transmitter and the other signal of the two outputs of the 2nd high-frequency transmitter;
a 1st power amplifier (29a) that amplifies the output of the 1st signal coupler;
a 2nd power amplifier (29b) that amplifies the output of the 2nd signal coupler;
a 1st impedance matching box (31a) that can match the impedance on the output side of the 1st power amplifier and transmits the output supplied by the 1st power amplifier to the pair of electrodes;
a 2nd impedance matching box (31b) that can match the impedance on the output side of the 2nd power amplifier and transmits the output supplied by the 2nd power amplifier to the pair of electrodes;
a 1st coaxial cable (32a) for connecting the output terminal of the 1st impedance matching box to the pair of electrodes;
a 2nd coaxial cable (32b) for connecting the output terminal of the 2nd impedance matching box to the pair of electrodes;
a 1st feeding point (20a) that is positioned at the end of the ungrounded electrode, is connected to a core line of the 1st coaxial cable, and is supplied power through the 1st coaxial cable; and
a 2nd feeding point (20b) that is positioned at the end of the ungrounded electrode opposite the 1st feeding point, is connected to a core line of the 2nd coaxial cable, and is supplied with power through the 2nd coaxial cable; and
by setting a distance between the 1st and the 2nd feeding points (20a), (20b) to an integer n times one half of the wavelength λ, i.e., nλ/2, of the power used for which the wavelength reduction rate is considered.

A high-frequency plasma CVD apparatus of a fifth invention relating to the present application is characterised by being provided with:

a vacuum vessel (1) that is provided with an exhaust system and adapted to set a substrate (11) therein,
raw material gas supply system (6), (8) that supplies raw material gas to the interior of the vacuum vessel;
a pair of electrodes formed from ungrounded electrode (2) and grounded electrode (4) for generating plasma,
2-output high-frequency power source (25a), (25b), (28a), (28b), (29a), (29b) that can generate alternately in time two standing waves between the pair of electrodes and set an interval of antinode positions of one of the two standing waves and antinode positions of the other to a quarter of the wavelength λ, namely, λ/4, of the power used for which the wavelength reduction rate is considered;
1st and 2nd impedance matching boxes (31a), (31b) for matching impedance at each output side of the 2-output high-frequency power source;
1st and 2nd balanced-to-unbalanced converters (40a), (40b) that connect respectively to the 1st and the 2nd impedance matching boxes and convert the power transmission line from an unbalanced transmission mode to a balanced transmission mode;
1st and 2nd balanced transmission lines (41a), (41b), (43a), (43b), (46a), (46b), (48a), (48b) that transmit outputs of the 1st and 2nd balanced-to-unbalanced converters to the respective electrode; and
1st and 2nd feeding points (20a), (20b) that are connected respectively to the 1st and the 2nd balanced transmission lines and are set at mutually opposite positions at the ends of the ungrounded electrode; and
by setting a distance between the 1st and the 2nd feeding points (20a), (20b) to an integer n times one half of the wavelength λ, i.e., nλ/2, of the power used for which the wavelength reduction rate is considered.

A high-frequency plasma CVD apparatus of a sixth invention relating to the present application is characterised by being provided with:

a vacuum vessel (1) that is provided with an exhaust system and adapted to set a substrate (11) therein;
a raw material gas supply system (6), (8) that supplies raw material gas to the interior of the vacuum vessel;
a pair of electrodes forming of ungrounded electrode (2) and grounded electrode (4) for generating plasma;
a 1st high-frequency transmitter (25a) with two outputs that can optionally pulse-modulate and can optionally set the phase difference of voltages at two outputs;
a 2nd high-frequency transmitter (25b) with two outputs that transmits a pulse-modulated sinusoidal wave in a different time band from a pulse-modulated sinusoidal wave output from the 1st high-frequency transmitter, and can arbitrarily set phase difference of voltages at the two outputs;
a 1st signal coupler (28a) that couples one signal of the two outputs of the 1st high-frequency transmitter and one signal of the two outputs of the 2nd high-frequency transmitter;
a 2nd signal coupler (28b) that couples the other signal of the two outputs of the 1st high-frequency transmitter and the other signal of the two outputs of the 2nd high-frequency transmitter;
a 1st power amplifier (29a) that amplifies the output of the 1st signal coupler;
a 2nd power amplifier (29b) that amplifies the output of the 2nd signal coupler;
a 1st impedance matching box (31a) that can match the impedance on the output side of the 1st power amplifier, and transmits the output supplied by the 1st power amplifier to the pair of electrodes;
a 2nd impedance matching box (31b) that can match the impedance on the output side of the 2nd power amplifier and transmits the output supplied by the 2nd power amplifier to the pair of electrodes;
a 1st balanced-to-unbalanced converter (40a) that transmits the output of the 1st impedance matching box to the pair of electrodes and converts the power transmission circuit from an unbalanced transmission mode to a balanced transmission mode;
a 1st coaxial cable (32a) that connects an output terminal of the 1st impedance matching box to the 1st balanced-to-unbalanced converter;
a 2nd balanced-to-unbalanced converter (40b) that transmits the output of the 2nd impedance matching box to the pair of electrodes and converts the power transmission circuit from an unbalanced transmission mode to a balanced transmission mode;
a 2nd coaxial cable (32b) that connects the output terminal of the 2nd impedance matching box to the 2nd balanced-to-unbalanced converter;
a 1st balanced transmission line (41a), (43a), (41b), (43b) that supplies the output of the 1st balanced-to-unbalanced converter to the pair of electrodes, namely, the 1st balanced transmission line (41a), (43a), (41b), (43b) has a constitution in which outer conductors of two coaxial cables having roughly the same length are short-circuited at least on both ends, and one end of each core line of the two coaxial cables is the input, and the other end is the output; a 2nd balanced transmission line (46a), (48a), (46b), (48b) that supplies the output of the 2nd balanced-to-unbalanced converter to the pair of electrodes, namely, the 2nd balanced transmission line (46a), (48a), (46b), (48b) has a constitution in which the outer conductors of two coaxial cables having roughly the same length are short-circuited on at least both ends, one end of each core line of the two coaxial cables is an input, and the other end is an output; a 1st feeding point (20a) that is positioned at the end of the ungrounded electrode (2), is connected to one of two core lines at the output of the 1st balanced transmission line, and is supplied with power through the 1st balanced transmission line;

a 3rd feeding point (21a) that is positioned at the end of the grounded electrode (4) and is positioned closest to the 1st feeding point, is connected to the other of the two core lines at the output of the 1st balanced transmission line, and is supplied with power through the 1st balanced transmission line;

a 2nd feeding point (20b) that is positioned at the end of the ungrounded electrode (2) opposite the 1st feeding point (20a), is connected to one of two core lines at the output of the 2nd balanced transmission line (46a), (48a), (46b), (48b), and is supplied with power through the 2nd balanced transmission line; and

a 4th feeding point (21b) that is positioned at the end of the grounded electrode (4) opposite the 3rd feeding point (21a), is connected to the other of the two core lines at the output of the 2nd balanced transmission line (46a), (48a), (46b), (48b), and is supplied with power through the 2nd balanced transmission line; and

wherein a distance between the 1st and the 2nd feeding points (20a), (20b) is set to an integer n times one half of the wavelength $\lambda$, i.e., $n\lambda/2$, of the power used for which the wavelength reduction rate is considered.

A semiconductor thin-film manufacturing method by using the plasma CVD of a seventh invention relating to the present application is a semiconductor thin-film manufacturing method for thin-film silicon solar cells using the high-frequency plasma CVD apparatus having a power source frequency in the VHF region (30 - 300 MHz) and is characterised by using high-frequency plasma CVD apparatus of any one of inventions 1 to 6 as a high-frequency plasma CVD apparatus to manufacture the semiconductor thin film for a thin-film silicon solar cell.

A high-frequency plasma CVD method of an eighth invention of the present application is a high-frequency plasma CVD method for forming a thin film on the surface of substrate (11) arranged in a vacuum vessel (1) by using plasma with a power source frequency in the VHF region (30 - 300 MHz) and is characterised in that a 1st feeding point (20a) is positioned on one end of ungrounded electrode (2), the 2nd feeding point (20b) is positioned at the other end of ungrounded electrode (2) and opposite the 1st feeding point in the transmission of the power wave, a distance between the 1st and the 2nd feeding points (20a), (20b) is set to an integer n times one half of wavelength $\lambda$, i.e., $n\lambda/2$, for which the wavelength reduction rate of the power used is considered, and the 1st standing wave that matched antinode positions to the positions of the 1st and the 2nd feeding points (20a), (20b) and the 2nd standing wave that matched node positions to the positions of the 1st and the 2nd feeding points (20a), (20b) are alternately generated in time.

A high-frequency plasma CVD method of a ninth invention relating to the present application is a high-frequency plasma CVD method for forming a thin film on the surface of substrate (11) arranged in a vacuum vessel (1) by using plasma with a power source frequency in the VHF region (30 - 300 MHz), and is characterised by comprising: a first step for setting the interval between 1st feeding point (20a) arranged at the end of ungrounded electrode (2) and 2nd feeding point (20b) arranged at a position opposite the 1st feeding point in the transmission of the power wave to an integer n times one half of the wavelength $\lambda$, i.e., $n\lambda/2$, for which the wavelength reduction rate of the power used is considered; a second step for determining the conditions for generating a 1st standing wave that matches antinode positions to the positions of the 1st and the 2nd feeding points (20a), (20b); a third step for determining the conditions for generating a 2nd standing wave that matches node positions to the positions of the 1st and the 2nd feeding points (20a), (20b); and a fourth step for forming a target thin film on the substrate (11) by alternately generating in different time bands the 1st and the 2nd standing waves determined, respectively, in the second and the third steps.

Effects of the Invention

According to the present invention, by setting the interval between 1st and 2nd feeding points to an integer n times one half of the wavelength $\lambda$, i.e., $n\lambda/2$, for which the wavelength reduction rate of the power used is considered, the supplied power can be efficiently consumed between the pair of electrodes; power losses can be suppressed; and plasma generated outside of the pair of electrodes, which is cause of generation of particles and powders, can be suppressed. Thus, compared to conventional technology, wasteful power consumption can be suppressed substantially. Furthermore, because abnormal discharges and arcing can be suppressed, a silicon semiconductor film can be deposited at a high speed over a large area, with a satisfactory uniformity, and a good reproducibility.

Thus, in manufacturing lines in the fields such as manufacture of integrated tandem thin-film silicon solar cell modules and manufacture of various apparatuses employing microcrystalline silicon film and crystalline silicon film, minimal power usage is designed; productivity and yield are improved; and product performance is improved. Therefore, the reduction in manufacturing costs is very large.

A plasma CVD apparatus and method that can realise all of the above items (a) to (e), which were difficult to realise in the conventional technology, can be provided.

According to the present invention, because all of the above items (a) to (e) can be realised, compared to the conventional technology, the contribution to the productivity improvement and the manufacturing cost reduction is substantial.

BRIEF DESCRIPTIONS OF THE DRAWINGS

[Fig. 1] Fig. 1 is a schematic drawing showing an entire plasma CVD apparatus related to a first exemplary embodiment of the present invention.
[Fig. 2] Fig. 2 is an exemplary drawing showing the constitution of the power supply to the pair of electrodes in the plasma CVD apparatus shown in Fig. 1.
[Fig. 3] Fig. 3 is a schematic drawing of the transmission of power supplied to the pair of electrodes in the plasma CVD apparatus shown in Fig. 1.
[Fig. 4] Fig. 4 is an explanatory drawing showing an example of the adjustment method of power transmission when power is supplied in the film deposition of the i-type microcrystalline silicon film using the plasma CVD apparatus shown in Fig. 1.
[Fig. 5] Fig. 5 is an explanatory drawing showing a typical example of the pulse-modulated output of the output from the 1st and 2nd pulse-modulation phase-variable 2-output transmitters shown in Fig. 1.
[Fig. 6] Fig. 6 is an explanatory drawing showing a typical example of the pulse-modulated sinusoidal signals output from the 1st and 2nd pulse-modulation phase-variable 2-output transmitters shown in Fig. 1.
[Fig. 7] Fig. 7 is an explanatory drawing showing intensities of the two standing waves generated between the pair of electrodes in the plasma CVD apparatus shown in Fig. 1.
[Fig. 8] Fig. 8 is an explanatory drawing of a typical example of film thickness distribution of an i-type microcrystalline silicon film obtained when adjusting film deposition conditions using the plasma CVD apparatus shown in Fig. 1.
[Fig. 9] Fig. 9 is a schematic drawing showing the entire plasma CVD apparatus relating to a second exemplary embodiment of the present invention.
[Fig. 10] Fig. 10 is an explanatory drawing of the power supply apparatus to the pair of electrodes using a balanced-to-unbalanced converter inside of the plasma CVD apparatus shown in Fig. 2.
[Fig. 11] Fig. 11 is a schematic drawing of the flow of the high-frequency current in the power supply apparatus to the pair of electrodes using the balanced-to-unbalanced converter shown in Fig. 10.
[Fig. 12] Fig. 12 is an explanatory drawing showing leakage current that is generated when the power is supplied to the pair of electrodes by using core lines and outer conductors of coaxial cables.
[Fig. 13] Fig. 13 is a schematic drawing of the balanced-to-unbalanced converter and the balanced transmission apparatus of the output using the balanced transmission line comprised of two coaxial cables. Explanation of Symbols

1 vacuum vessel
2 1st electrode
3 substrate heater which is not shown
4 2nd electrode
5 insulating support material
6 gas mixing box
7 rectifier hole
8 raw material gas supply pipe
9a, 9b exhaust pipes
10 vacuum pump which is not shown
11 substrate
12 substrate lifter
13 gate valve which is not shown
14 bellows
15a, 15b 1st and 2nd connection conductors
16a, 16b 3rd and 4th connection conductors
17 gas shower hole
20a, 20b 1st and 2nd feeding points

21a, 21b 3rd and 4th feeding points

22a, 22b 1st and 2nd insulation caps

24 synchronization signal transmission cable

25a, 25b 1st and 2nd pulse-modulation, phase-adjustable, 2-output transmitters

26a, 26b 1st and 2nd output terminals of 1st pulse-modulation, phase-adjustable, 2-output transmitter

27a, 27b 1st and 2nd output terminals of 2nd pulse-modulation, phase-adjustable, 2-output transmitter

28a, 28b 1st and 2nd couplers

29a, 29b 1st and 2nd power amplifiers

30a, 30b 1st and 2nd coaxial cables

31a, 31b 1st and 2nd impedance matching boxes

32a, 32b 1st and 2nd coaxial cables

33a, 33b 1st and 2nd current introduction terminals

34a, 34b 3rd and 4th coaxial cables

35a, 35b core lines

40a, 40b 1st and 2nd LC bridge balanced-to-unbalanced converters

41a, 41b 5th and 6th coaxial cables

42 3rd current introduction terminal

43a, 43b 7th and 8th coaxial cables

43a, 43b core lines

46a, 46b 9th and 10th coaxial cables

47 4th current introduction terminal

48a, 48b 11th and 12th coaxial cables

49a, 49b core lines

53a, 53b 1st and 2nd outer conductor fittings

PREFERRED MODES FOR CARRYING OUT THE INVENTION

The preferred modes to implement the present invention are described in detail below with reference to the drawings. In each drawing, the same reference numbers are applied to similar parts, and duplicate descriptions are omitted.

In the following description, as an example of the plasma CVD apparatus and the plasma CVD method, an apparatus and a method that deposit an i-type microcrystalline semiconductor layer for a solar cell are described, but the target of the invention in the present application is not limited to the following examples.

Example 1

First, plasma CVD apparatus and plasma CVD method relating to the first exemplary embodiment of the present invention are explained with reference to Figs. 1 to 8.

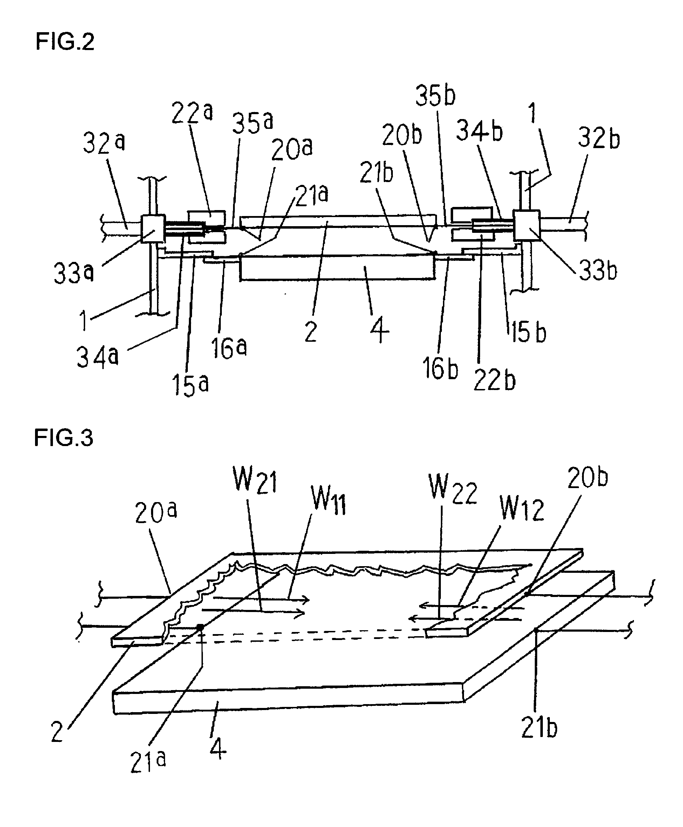

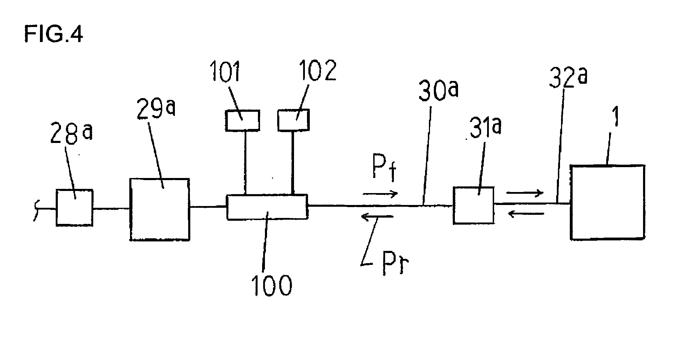

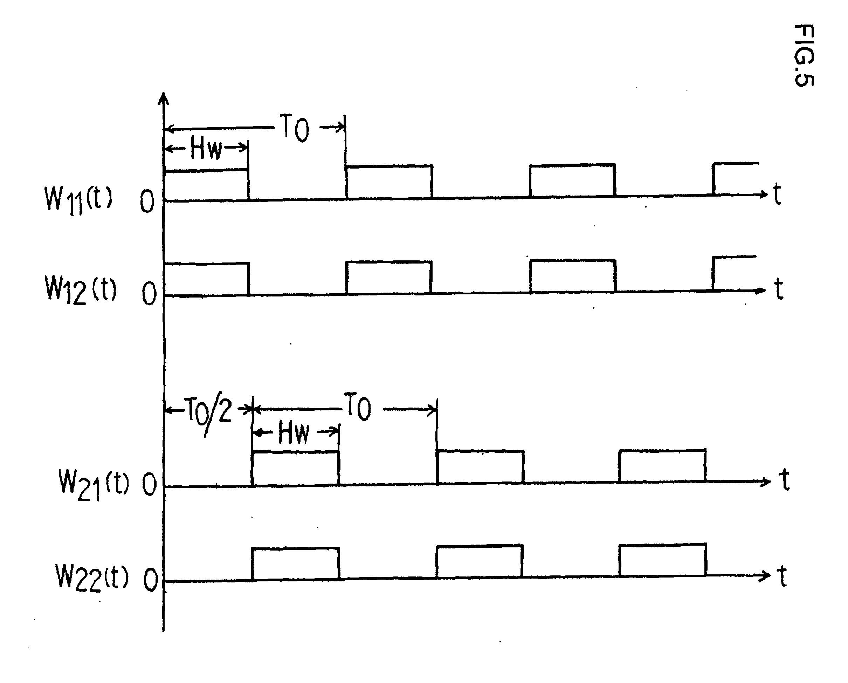

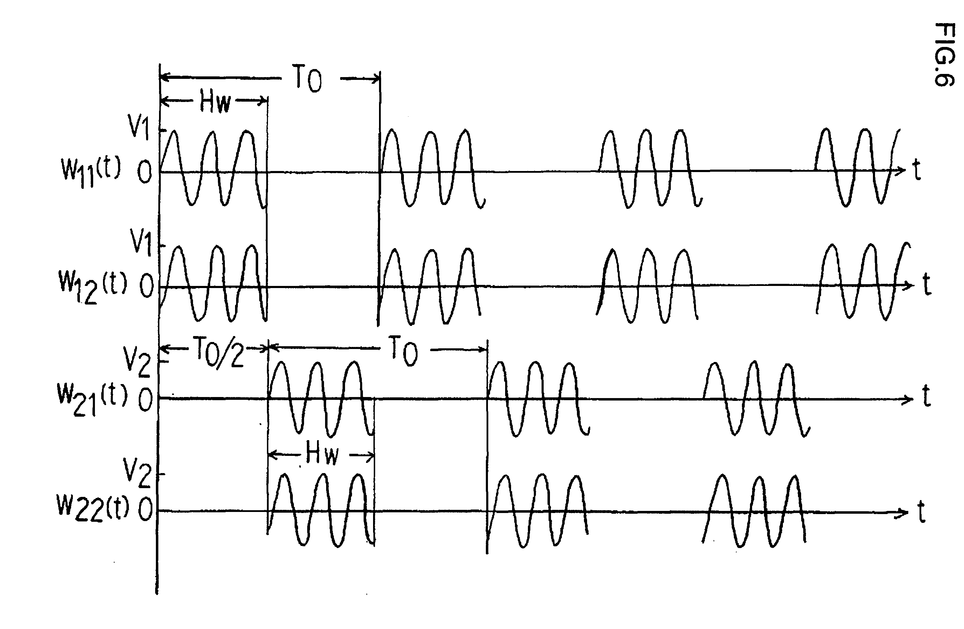

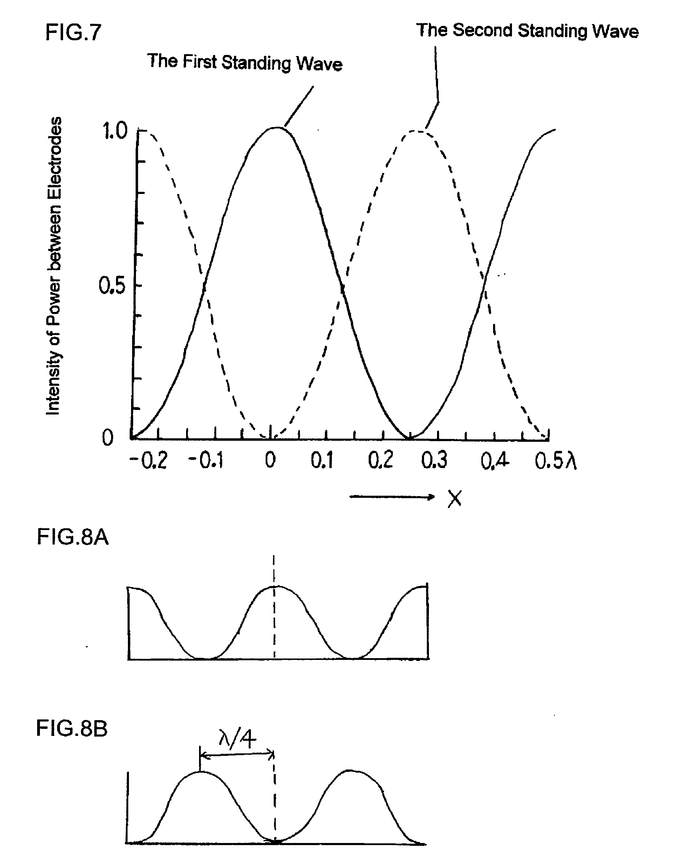

Fig. 1 is a schematic view showing the entire plasma CVD apparatus relating to the first exemplary embodiment of the present invention. Fig. 2 is an explanatory drawing showing the structure of the power supply unit to the pair of electrodes in the plasma CVD apparatus shown in Fig. 1. Fig. 3 is a schematic view of the transmission of power fed to the pair of electrodes in the plasma CVD apparatus shown in Fig. 1. Fig. 4 is an explanatory drawing showing the adjustment method of the power transmission when the power is supplied in the film deposition of the i-type microcrystalline silicon film using the plasma CVD apparatus shown in Fig. 1. Fig. 5 is an explanatory drawing illustrating a typical example of the pulse-modulated outputs from the 1st and the 2nd pulse-modulation, phase-adjustable, 2-output transmitters shown in Fig. 1. Fig. 6 is an explanatory drawing illustrating typical examples of the sinusoidal signals of the pulse-modulated output from the 1st and the 2nd pulse-modulation, phase-adjustable, 2-output transmitters shown in Fig. 1. Fig. 7 is an explanatory drawing showing the intensities of the two standing waves generated between the pair of electrodes in the plasma CVD apparatus shown in Fig. 1. Fig. 8 is an explanatory drawing of a typical example of the film thickness distribution of the i-type microcrystalline silicon film obtained when adjusted based on the film deposition conditions used by the plasma CVD apparatus shown in Fig. 1.

First, the structure of the apparatus is explained. In Figs. 1, 2, and 3, reference number 1 is a vacuum vessel. A pair of electrodes, to be explained later, that converts the raw material gas into plasma, namely, a 1st electrode 2 that is ungrounded and a 2nd electrode 4 that is grounded and incorporates substrate heater 3, which is not shown, are arranged in the vacuum vessel 1.

Reference number 2 is the 1st electrode that is fixed in the vacuum vessel 1 with an insulating support material 5 and a gas mixing box 6 therebetween. First electrode 2 has rectangular flat plates (termed as "plates" hereinafter) as shown in Figs. 2 and 3, positioned opposing each other. For example, the specific size has exterior dimensions of a 1.65-m length x 0.3-m width x 20-mm thick.

As will be described later, the size in the transmission direction of the power supplied to the electrodes, here the numerical value of 1.65-m length is significant because of the relationship to the wavelength of the supplied power.

In addition, as shown in Fig. 1, 1st electrode 2 has a gas shower hole 17 for ejecting the raw material gas. Hole 17 has a diameter of approximately 0.4 to 0.8 mm, for example, a diameter of approximately 0.5 mm, and a plurality thereof is provided.

Reference number 4 is the 2nd electrode which incorporates substrate heater 3, which is not shown. The temperature of substrate 1 positioned thereon can be set to any temperature in the range from 100°C to 300°C. Second electrode 4 incorporates a pipe that passes refrigerant in addition to substrate heater 3 and can control the temperature of the surface of substrate heater [sic. 2nd electrode] 4.

As shown in Figs. 2 and 3, 2nd electrode 4 is a rectangular plate and is positioned opposing 1st electrode 2. For example, the specific size has exterior dimensions of a 1.65-m length x 0.4-m width x 150-mm thick.

First and 2nd feeding points 20a, 20b are arranged on 1st electrode 2. The first and 2nd feeding points 20a, 20b are connecting points of the power supply system, to be explained later, and electrode 2, and supply power from that position. In addition, 1st and 2nd feeding points 20a, 20b have mutually opposing positions, are set at the ends of the electrode, and are at opposing points in the transmission of the high-frequency power wave.

Third and 4th feeding points 21a, 21b are arranged on the 2nd electrode 4. Third and 4th feeding points 21a, 21b are connecting points of the power supply system, to be explained later, and electrode 4, and supply power from that position. In addition, 3rd and 4th feeding points 21a, 21b have mutually opposing positions, are set at the ends of the electrode, and are at opposing points in the transmission of the high-frequency power wave.

The interval between 1st and 2nd electrodes 2, 4 can be freely set beforehand when substrate lifter 12, to be described later, is moved vertically and is set in the range from 5 mm to 40 mm, for example, 8 mm.

The interval between 1st and 2nd feeding points 20a, 20b is set to the integer n times one half of the wavelength $\lambda$, i.e., $n\lambda/2$, of the power used considering the wavelength reduction rate. Similarly, the interval between 3rd and 4th feeding points 21a, 21b is set to the integer n times one half of the wavelength $\lambda$, i.e., $n\lambda/2$, of the power used considering the wavelength reduction rate.

Here, in the plasma generation of silane gas to be described later, using power having a frequency in the VHF band, for example, 100 MHz frequency, is considered, and 1.65 m is set. A wavelength reduction rate $\lambda/\lambda_o$ of 0.55 (i.e., $\lambda = 0.55 \times 3$ m) is expected, and $n\lambda/2 = 2 \times 1.65$ m/2 = 1.65 m is set.

However, $\lambda$ is the wavelength during plasma generation of the power used, and $\lambda_o$ is a wavelength in vacuum of electromagnetic waves having a 100 MHz frequency.

The wavelength $\lambda$ of the power used considering the wavelength reduction rate is the wavelength $\lambda$ when power is transmitted between the pair of electrodes 2,4 that generate plasma. For example, when power having a 60 MHz frequency is used in the generation of plasma from silane gas, if the pressure is approximately 40 to 530 Pa (0.3 to 4 Torr), then $\lambda$ = approximately 3 m (wavelength $\lambda_o$ = 5 m in vacuum). In addition, when power having a 100 MHz frequency is used, if the pressure is approximately 40 to 530 Pa (0.3 to 4 Torr), then $\lambda$ = approximately 1.5 to 1.65 m (wavelength $\lambda_o$ = 3 m in vacuum).

The wavelength $\lambda$ of the power used considering the wavelength reduction rate is shorter than the wavelength $\lambda_o$ when the power used is transmitted in vacuum. The ratio of wavelength $\lambda$ to wavelength $\lambda_o$, i.e., $\lambda/\lambda_o$, is $\lambda/\lambda_o$ = approximately 0.6 for the plasma of a silane gas when the pressure is approximately 40 to 530 Pa (0.3 to 4 Torr), and the plasma density is approximately 4 to 6 x $10^9$/cm$^3$. The ratio is $\lambda/\lambda_o$ = approximately 0.5 to 0.55 when the pressure is 530 to 1333 Pa (4 to 10 Torr) and the plasma density is approximately 6 to 10 x $10^9$/cm$^3$.

When the wavelength $\lambda$ of the power used considering the wavelength reduction rate is not known, as will be explained later, the value of the wavelength of the power used considering the wavelength reduction rate is measured beforehand, and the data is used to design and manufacture the electrode.

Reference numbers 22a, 22b are the 1st and the 2nd insulation caps that have the function of suppressing abnormal discharges (arcing) at the connecting part of 3rd coaxial cable 34a to be explained later and 1st feeding point 20a, and the connecting part of 4th coaxial cable 34b to be explained later and 2nd feeding point 20b, respectively. The material therein is, for example, highly pure aluminium.

Gas mixing box 6 has the function of uniformly supplying silane gas (SiH4) supplied through a raw material gas supply pipe 8 and a gas such as hydrogen through rectifier holes (nozzles) 7 to the gap between the pair of electrodes 2 and 4. The raw material gas supply pipe 8 is an insulating material, which is not shown, and is electrically insulated. After the supplied raw material gas such as SiH4 is formed into a plasma between the pair of electrodes 2 and 4, the gas is ejected to the outside of vacuum vessel 1 by exhaust pipes 9a, 9b and vacuum pump 10, which is not shown.

Reference number 12 is a substrate lifter that receives substrate 11 on 2nd electrode 4 from substrate carrying in and out gate 13, which is not shown, and moves to a position where the interval with ungrounded electrode 2 has the specified value, for example, moves to a position where the interval between 1st and 2nd electrodes 2, 4 becomes 8 mm. The vertical position of substrate lifter 12 can be arbitrarily set, and the range between 1st and 2nd electrodes 2, 4 is from, for example, 5 mm to 40 mm.

When substrate lifter 12 moves vertically, bellows 14 is used to maintain an airtight vacuum vessel 1.

In addition, to improve the electrical conduction between grounded electrode 4 and the inner wall of vacuum vessel 1 as will be explained later, 1st connection conductor 15a and 2nd connection conductor 15b attached to the inner wall of vacuum vessel 1, and 3rd connection conductor 16a and 4th connection conductor 16b attached to 2nd electrode 4 are arranged. Corresponding to the gap between 1st and 2nd electrodes 2, 4, the positioning of 1st connection conductor 15a and 2nd connection conductor 15b can be arbitrarily set.

In addition, when 1st connection conductor 15a and 3rd connection conductor 16a, and 2nd connection conductor 15b and 4th connection conductor 16b are in contact with each other, there is a spring characteristic so there is pushing against each other. First connection conductor 15a and 3rd connection conductor 16a, and 2nd connection conductor 15b and 4th connection conductor 16b are set to enable good reproducibility and to maintain a conducting state.

Reference number 11 is a substrate that uses a substrate lifter 12 and a substrate carrying in and out gate 13, which is not shown, to position on the 2nd electrode 4, and is heated to a specified temperature by substrate heater 3, which is not shown. Here, the substrate 11 is glass having dimensions of 1.5 m x 0.25 m x 4-mm thick.

The pressure in vacuum vessel 1 is monitored by a pressure gauge, which is not shown, and automatically adjusted and set to the specified value by a pressure regulation valve, which is not shown. For the first exemplary embodiment, when the raw material gas has a flow approximately of 500 sccm to 1500 sccm, the pressure can be adjusted to approximately 0.01 Torr to 10 Torr (1.33 Pa to 1330 Pa). The ultimate pressure of the vacuum in vacuum vessel 1 is approximately 2 to 3E-7 Torr (2.66 to 3.99E-5 Pa).

Reference number 25a is the 1st pulse-modulation, phase-adjustable, 2-output transmitter that generates a sinusoidal signal having any frequency from 30 MHz to 300 MHz (VHF band), for example, 100 MHz, pulse-modulates the sinusoidal wave, and can arbitrarily set any phase difference between the two pulse-modulated sinusoidal signals output from two output terminals.

The two pulse-modulated sinusoidal signals are represented as follows. Let the angular frequency be $\omega$, the time be t, and the initial phases be $\theta_1$, $\theta_2$, then signals $W_{11}$, $W_{12}$ output from the two output terminals 26a, 26b of 1st pulse-modulation, phase-adjustable, 2-output transmitter 25a are:

$$W_{11}(t) = \sin(\omega t + \theta_1)$$

$$W_{12}(t) = \sin(\omega t + \theta_2).$$

The phase difference of the two sinusoidal signals output from two output terminals of the phase-variable, 2-output transmitter 25a, as well as the pulse width Hw and the period T0 of the pulse modulation thereof, can be set to any value in the phase difference adjuster and the pulse modulation adjuster associated with transmitter 25a.

In addition, 1st pulse-modulation, phase-adjustable, 2-output transmitter 25a transmits the pulse-modulated synchronization signal to 2nd pulse-modulation, phase-adjustable, 2-output transmitter 25b through synchronization signal transmission cable 24.

One output at the two output terminals of 1st pulse-modulation, phase-adjustable, 2-output transmitter 25a is transmitted to first coupler 28a to be described later, and other output to 2nd coupler 28b to be described later.

Reference number 28a is a first coupler that couples one output signal of the two output terminals of 1st pulse-modulation, phase-adjustable, 2-output transmitter 25a, and one output signal of the two output terminals of 2nd pulse-modulation, phase-adjustable, 2-output transmitter 25b to be described later, and transmits to a 1st amplifier 29a to be described later.

Reference number 29a is the 1st amplifier that amplifies the power of the signal transmitted from first coupler 28a. Reference number 30a is a coaxial cable that transmits the output of 1st amplifier 29a to a 1st impedance matching box 31a to be described later.

Reference number 31a is the 1st impedance matching box that matches and adjusts the output impedance of 1st amplifier 29a and the impedance of the plasma generated between pair of electrodes 2, 4 which is its load so that the output of 1st amplifier 29a is efficiently transmitted to the plasma generated between pair of electrodes 2, 4 to be described later.

Reference number 32a is the 1st coaxial cable that supplies the outputs of the 1st amplifier to the 1st and 3rd feeding points 20a, 21a through 1st current introduction terminal 33a to be described later, 3rd coaxial cable 34a, and first core line 35a, also through the 1st connection conductor 15a, 3rd connection conductor 16a, respectively.

Reference number 33a is the 1st current introduction terminal attached to the wall of vacuum vessel 1 that maintains the airtightness of the vacuum vessel, and connects the 1st coaxial cable 32a and 3rd coaxial cable 34a.

Reference number 34a is 3rd coaxial cable that connects the first coreline 35a to the (1st) electrode 2 at the 1st feeding point 20a. The outer conductor thereof is connected to the 2nd electrode 4 at the 3rd feeding point 21a through the inner wall of vacuum vessel 1, 1st connection conductor 15a, and 3rd connection conductor 16a.

First insulating cap 22a is installed at the end of 3rd coaxial cable 34a, and an abnormal discharges (arcing) are suppressed at the connecting part of 3rd coaxial cable 34a and 1st feeding point 20a.

As a result, the outputs of 1st amplifier 29a transmitted through 1st and 3rd coaxial cables 32a, 34a are supplied to between 1st and 2nd electrodes 2, 4 through 1st and 3rd feeding points 20a, 21a.

An additional explanation of the function of the abovementioned 1st amplifier 29a is presented.

A monitor of the output values (travelling wave), which is not shown, and a monitor of the reflected wave reflected back from the downstream side are attached to 1st amplifier 29a. In addition, an isolator is attached to protect the electrical circuit of first output amplifier 29a caused by the reflected waves.

For example, as a monitor of the output value (travelling wave) and a monitor of the reflected wave reflected back from the downstream side use is made of a device shown in Fig. 4. In Fig. 4, the output (travelling wave) Pf of 1st amplifier 29a is detected by travelling wave detector 101 via directional coupler 100. Reflected wave Pr reflected back from the downstream side is detected by reflected wave detector 102 via directional coupler 100.

In Fig. 4, first, the adjustment of the output of 1st amplifier 29a supplies, for example, approximately 20 to 30% of the maximum output of 1st amplifier 29a through 1st impedance matching box 31a and 1st coaxial cable 32a to 1st and 2nd electrodes 24 [*sic,* 2, 4] inside of vacuum vessel 1.

Next, while the detector of the travelling wave Pf and the reflected wave Pr attached to 1st amplifier 29a is monitored, the reactance (L and C) of 1st impedance matching box 31a is adjusted. While the reactance (L and C) of 1st impedance matching box 31a is adjusted, the conditions where the reflected wave Pr becomes the minimum value are selected.

Then the output of 1st amplifier 29a is set to a specified numerical value, and the conditions where the reflected wave Pr becomes the minimum value are again selected while the reactance (L and C) of 1st impedance matching box 31a is readjusted at the output.

The adjustment of this impedance matching box, that is, the condition where the reflected wave Pr becomes the minimum value, does not change unless the plasma generation conditions change, a particularly long time is not required.

Reference number 25b is the 2nd pulse-modulation, phase-adjustable, 2-output transmitter that can generate a sinusoidal signal having any frequency ranging from 30 MHz to 300 MHz (VHF band), for example, 100 MHz, pulse-modulate the sinusoidal signals, and arbitrarily set any phase difference for the two pulse-modulated sinusoidal signals output from the two output terminals.

The two pulse-modulated sinusoidal signals are represented as follows. Let the angular frequency be $\omega$, the time be t, and the initial phases be $\alpha_1$, $\alpha_2$, then signals $W_{21}$, $W_{22}$ output from output terminals 27a, 27b of 2nd pulse-modulation, phase-adjustable, 2-output transmitter 25b are:

$$W_{21}(t) = \sin(\omega t + \alpha_1)$$

$$W_{22}(t) = \sin(\omega t + \alpha_2).$$

The phase difference of the two sinusoidal signals output from the two output terminals of 2nd pulse-modulation, phase-adjustable, 2-output transmitter 25b as well as the pulse width Hw and the period T0 of the pulse modulation thereof can be set to any arbitrary value in a phase difference adjuster and a pulse modulator assigned to the transmitter 25b.

In addition, 2nd pulse-modulation, phase-adjustable, 2-output transmitter 25b can receive the pulse-modulated synchronization signal transmitted from the 1st pulse-modulation, phase-adjustable, 2-output transmitter 25a via synchronization signal transmission cable 24, and can generate the signal synchronized thereto.

One output of the two output terminals of the 2nd pulse-modulation, phase-adjustable, 2-output transmitter 25b is transmitted to a first coupler 28a, and the other output is transmitted to a 2nd coupler 28b to be described later.

Reference number 28b is the 2nd coupler that couples one output signal of the two output terminals of the 2nd pulse-modulation, phase-adjustable, 2-output transmitter 25b and one output signal of the two output terminals of the 1st pulse-modulation, phase-adjustable, 2-output transmitter 25a, and transmits to a 2nd amplifier 29b to be explained later.

Reference number 29b is the 2nd amplifier that amplifies the power of the signal transmitted from 2nd coupler 28b. Reference number 30b is a coaxial cable that transmits the output of 2nd amplifier 29b to a 2nd impedance matching box 31b to be described.

Reference number 31b is the 2nd impedance matching box that matches and adjusts the impedance of the plasma generated between pair of electrodes 2, 4 as a load (of 2nd amplifier 29b) to the output impedance of the 2nd amplifier 29b so that the output of 2nd amplifier 29b is efficiently transmitted to the plasma generated between the pair of electrodes 2, 4.

Reference number 32b is the 2nd coaxial cable that supplies the outputs of the 2nd amplifier to the 2nd and 4th feeding points 20b, 21b through 2nd current introduction terminal 33b, 4th coaxial cable 34b, and the core line 35b, also through the 2nd connection conductor 15b, 4th connection conductor 16b, respectively.

Reference number 33b is the 2nd current introduction terminal attached to the wall of vacuum vessel 1 that maintains the airtightness of the vacuum vessel, and connects the 2nd coaxial cable and the 4th coaxial cable.

Reference number 34b is the 4th coaxial cable that connects the core line 35b thereof to the (1st) electrode 2 at 2nd feeding point 20b, and connects the outer conductor thereof to the 2nd electrode 4 at 4th feeding point 21b through the inner wall of vacuum vessel 1, 2nd connection conductor 15b, and 4th connection conductor 16b.

Second insulating cap 22b is installed at the end of 4th coaxial cable 34b to suppress abnormal discharges (arcing) at the connection part of 4th coaxial cable 34b and 2nd feeding point 20b.

As a result, the outputs of 2nd amplifier 29b transmitted through 2nd and 4th coaxial cables 32b, 34b are supplied through 2nd and 4th feeding points 20b, 21b to the gap between 1st and 2nd electrodes 2, 4.

An additional explanation of the function of the 2nd amplifier 29b is presented.

Similar to the 1st amplifier 29a, the monitor of the output value (travelling wave), which is not shown, and the monitor of the reflected wave reflected back from the downstream side are assigned to the 2nd amplifier 29b. In addition, an isolator is assigned to protect the electrical circuit of 2nd amplifier 29b from the reflected waves.

In addition, the monitor of the output value (travelling wave) and the monitor of the reflected wave that is reflected back from the downstream side are similar to those of the 1st amplifier 29a.

The adjustment method of the 2nd amplifier 29b is the same as that for the 1st amplifier 29a.

To facilitate the explanation, the power that one of the two outputs of 1st pulse-modulation, phase-adjustable, 2-output transmitter 25a, that is, the output signal of output terminal 26a, transmits to 1st feeding point 20a and 3rd feeding point 21a through the 1st coupler 28a, 1st amplifier 29a, coaxial cable 30a, 1st impedance matching box 31a, 1st coaxial cable 32a, 1st current introduction terminal 33a, and the 3rd coaxial cable 34a is referred to as the 1st power.

Similarly, the power that one of the two outputs of 1st pulse-modulation, phase-adjustable, 2-output transmitter 25a, that is, the output signal of output terminal 26b, transmits to 2nd feeding point 20b and 4th feeding point 21b through 2nd coupler 28b, 2nd amplifier 29b, coaxial cable 30b, 2nd impedance matching box 31b, 2nd coaxial cable 32b, 2nd current introduction terminal 33b, and the 4th coaxial cable 34b is referred to as the 2nd power.

In addition, the power that one of the two outputs of the 2nd pulse-modulation, phase-adjustable, 2-output transmitter 25b, that is, the output signal of the output terminal 27a, transmits to 1st feeding point 20a and 3rd feeding point 21a through 1st coupler 28a, 1st amplifier 29a, coaxial cable 30a, 1st impedance matching box 31a, 1st coaxial cable 32a, 1st current introduction terminal 33a, and 3rd coaxial cable 34a is referred to as the 3rd power.

The power that one of the two outputs of the 2nd pulse-modulation, phase-adjustable, 2-output transmitter 25b, that is, the output signal of output terminal 27b, transmits to 2nd feeding point 20b and 4th feeding point 21b through 2nd coupler 28b, 2nd amplifier 29b, coaxial cable 30b, 2nd impedance matching box 31b, 2nd coaxial cable 32b, 2nd current introduction terminal 33b, and 4th coaxial cable 34b is referred to as the 4th power.

To explain the temporal relationships of the 1st, 2nd, 3rd, and 4th powers, the concept is explained while referring to Figs. 5 and 6. In Fig. 5, the horizontal axis indicates time t, and the vertical axis indicates the power. In Fig. 6, the horizontal axis indicates the time t, and the vertical axis indicates the voltage.

Typical examples of the pulse-modulated 1st power supplied to the interval between 1st and 3rd feeding points 20a, 21a and the pulse-modulated 2nd power to the interval supplied between 2nd and 4th feeding points 20b, 21b are indicated by W11(t) and W12(t), respectively, in Figs. 5 and 6. The two powers are sinusoidal waves pulse-modulated with pulse width Hw and period T0.

Typical examples of the pulse-modulated 3rd power supplied to the interval between 1st and 3rd feeding points 20a, 21a and the pulse-modulated 4th power supplied to the interval between 2nd and 4th feeding points 20b, 21b are indicated by W21(t) and W22(t), respectively, in Figs. 5 and 6. The two power waves are sinusoidal waves pulse-modulated with pulse width Hw, period T0, and each rises at a half period from the pulse rising time of the pulse modulation of W11(t) and W12(t), namely, at a time delayed TO/2.

Here, the operation is explained by setting each of the distance between 1st feeding point 20a and 2nd feeding point 20b shown in Figs. 1, 2, and 3 and the distance between 3rd feeding point 21a and 4th feeding point 21b to an integer n times one half of the wavelength $\lambda$, i.e., $n\lambda/2$, of the power used for which the wavelength reduction rate is considered.

When the 1st power is supplied to the pair of electrodes 2, 4 through 1st and 3rd feeding points 20a, 21a, the power wave is transmitted as a travelling wave from the 1st feeding point 20a side to the 2nd feeding point 20b side. When the power wave thereof arrives at the end of the pair of electrodes positioned at 2nd and 4th feeding points 20b, 21b, the reflection occurs at the end because the end forms a discontinuity in the impedance. The reflected wave is transmitted in a direction directed from the 2nd feeding point 20b to the 1st feeding point 20a.

If the travelling wave of the 1st power would not be reflected by the ends of the pair of electrodes installed with 2nd and 4th feeding points 20b, 21b, the travelling wave will be transmitted through 2nd coaxial cable 32b and arrives at 2nd impedance matching box 31b, and is then reflected back by 2nd impedance matching box 31b to return. In this case, there is a problem that the consumption of power between 2nd feeding point 20b and 2nd impedance matching box 31b, that is, the remaining problem is the power consumption other than the plasma generation between the pair of electrodes 2, 4.

Standing waves are generated by interference phenomenon in which the travelling wave of the power supplied from the 1st feeding point 20a side and the reflected wave reflected at the ends of the pair of electrodes on the 2nd feeding point 20b side overlap. In this case, the distance between the supply point of the travelling wave and the generation point of the reflected wave is set to an integer n times one half of the wavelength $\lambda$, i.e., $n\lambda/2$, of the power used for which the wavelength reduction rate is considered. Therefore, a phenomenon appears in which the antinodes of the generated standing waves are readily generated at the supply point of the travelling wave and the generation point of the reflected wave. Similarly, a phenomenon appears in which the nodes of the generated standing waves are readily generated at the supply point of the travelling wave and the generation point of the reflected wave. This phenomenon resembles the resonance phenomenon found in the acoustic engineering field.

The action of reducing consumption other than between the pair of electrodes is created by a phenomenon resembling the resonance phenomenon of the travelling wave of the 1st power and the reflected wave thereof. Namely, this action suppresses to the minimum the power losses in the power supply line destined to the pair of electrodes.

Similarly, when the 2nd power is supplied to the pair of electrodes 2, 4 through 2nd and 4th feeding points 20b, 21b, the power wave is transmitted as the travelling wave from the 2nd feeding point 20b side to the 1st feeding point 20a side. When the power wave arrives at the ends of the pair of electrodes installed with 1st and 3rd feeding points 20a, 21a, reflection occurs at the end because the end forms a discontinuity in the impedance. The reflected wave is transmitted in the direction directed from the 1st feeding point 20a to the 2nd feeding point 20b.

If the travelling wave of the 2nd power is not reflected by the ends of the pair of electrodes that positioned 1st and 3rd feeding points 20a, 21a, the travelling wave is transmitted through 1st coaxial cable 32a and arrives at the 1st impedance matching box 31a, and is then reflected back by 1st impedance matching box 31a. In this case, there is a problem in the consumption of power between 1st feeding point 20a and 1st impedance matching box 31a, that is, the remaining problem is the power consumption other than the plasma generation between the pair of electrodes 2, 4.

Standing waves are generated by the interference phenomenon in which the travelling wave of the power supplied from the 2nd feeding point 20b side and the reflected wave reflected at the ends of the pair of electrodes on the 1st feeding point 20a side overlap. In this case, the distance between the supply point of the travelling wave and the generation point of the reflected wave is set to an integer n times one half of the wavelength $\lambda$, i.e., $n\lambda/2$, of the power used for which the wavelength reduction rate is considered. Therefore, a phenomenon appears in which the antinodes of the generated standing waves are readily generated at the supply point of the travelling wave and the generation point of the reflected wave. Similarly, a phenomenon appears in which the nodes of the generated standing wave are readily generated at the supply point of the travelling wave and the generation point of the reflected wave. This phenomenon resembles the resonance phenomenon found in the acoustic engineering field.

The action of reducing consumption other than between the pair of electrodes is created by a phenomenon resembling the resonance phenomenon of the travelling wave of the 2nd power and the reflected wave thereof. This action suppresses to the minimum, the power losses in the power supply line destined to the pair of electrodes.

Similar to the above, even in the supply of the 3rd and the 4th powers, there is an action to suppress, to the minimum, the power losses in the power supply line destined to the pair of electrodes by a phenomenon resembling the resonance phenomenon of the travelling wave and the reflected wave of the 3rd and 4th powers.

Next, the method that uses the plasma CVD apparatus having the above constitution to deposit the i-type micro (or nano)crystalline (represented cumulatively by "microcrystalline") silicon film for an integrated tandem thin-film silicon solar cell is explained.

In the deposition of the i-type microcrystalline silicon film, the raw material gas, pressure, density of the power to be applied, and the substrate temperature are known. For example, the conditions described in Patent Document 1 and Non-Patent Document 1 are adopted.

However, it is required that the unique conditions related to the plasma CVD apparatus having the above constitution is confirmed in advance and adjusted by the procedure shown below. Then, the film deposition of the target i-type microcrystalline silicon film is performed.

[Step 1] In the deposition conditions of the target i-type microcrystalline silicon film, the knowledge about the raw material gas, pressure, density of the power to be applied, and the substrate temperature is adopted. Under these conditions, the wavelength $\lambda$ of the power transmitted between the pair of electrodes 2, 4 is measured. Based on this measurement data, the distance between 1st and 2nd feeding points 20a, 20b is confirmed to be set to an integer n times one half of the wavelength $\lambda$, i.e., $n\lambda/2$, of the power.

[Step 2] The required data are determined for the adjustment of the antinode positions of the 1st standing wave that is generated when the 1st and the 2nd powers are supplied to the pair of electrodes 2, 4. Specifically, the relationship between the setting value of the phase difference of the two outputs of the 1st pulse-modulation, phase-adjustable, 2-output transmitter 25a and the antinode position(s) of the 1st standing wave is determined.

[Step 3] The required data are determined for the adjustment of the antinode position(s) of the 2nd standing wave that is generated when the 3rd and the 4th powers are supplied to the pair of electrodes 2, 4. Specifically, the relationship between the setting value of the phase difference of the two outputs of the 2nd pulse-modulation, phase-adjustable, 2-output transmitter 25b and the antinode position(s) of the 2nd standing wave is determined.

[Step 4] The 1st standing wave and the 2nd standing wave are generated, and the target i-type microcrystalline silicon film is deposited.

To facilitate the explanation, below, the plasma CVD method used in Step 1 to Step 4 is explained under the premise the same apparatus is used in all of the steps. However, in Step 1, another apparatus, for example, an apparatus for research and development, can be used. However, preferably, Step 2 to Step 4 use the same apparatus.

[Step 1]

In Fig. 1 to Fig. 4, a substrate 11 is positioned on the 2nd electrode 4 beforehand and a vacuum pump 10, which is not shown, is operated to remove the contaminated gas in a vacuum vessel 1. Then the pressure is maintained at 5.0 Torr (665 Pa) while continuing to supply $SiH_4$ gas through raw material gas supply pipe 8 at 0.8 to 1.0 SLM (gas flow calculated in standard condition: L/minute), for example, 0.8 SLM, and hydrogen at 5.0 SLM. The substrate temperature is held in the range from 100°C to 350°C, for example, at 220°C.

The size of substrate 11 is adapted to the size of the 1st electrode and is set to 1.65-m length x 0.3-m width (4-mm thick). Next, for example, when the frequency of the 1st power and the 2nd power is 100 MHz, the pulse width Hw = 400 $\mu$sec and the pulse period T0 = 1 msec, then the total power of 1 to 1.5 kW, for example, 1 kW is supplied. Since the pulse width Hw is 400 $\mu$sec, and pulse period T0 is 1 msec, the duty ratio is 400 $\mu$sec/1 msec = 0.4.

The phase difference between the two outputs of 1st pulse-modulation, phase-adjustable, 2-output transmitter 25a is set to, for example, zero, the pulse width Hw = 400 $\mu$sec and the pulse period T0 = 1 msec. The output of 1st power amplifier 29a is set to 500 W. The output thereof is supplied through the 1st impedance matching box 31a, 1st coaxial cable 32a, 1st current introduction terminal 33a, and 3rd coaxial cable 34a to 1st and 3rd feeding points 20a, 21a. The output of 2nd power amplifier 29b is set to 500 W. The output thereof is supplied through the 2nd impedance matching box 31b, 2nd coaxial cable 32b, 2nd current introduction terminal 33b, and 4th coaxial cable 34b to the interval between 2nd and 4th feeding points 20b, 21b.

In this case, by adjusting the 1st impedance matching box 31a and the 2nd impedance matching box 31b, a state can be established so that the reflected wave of the supplied power does not return to the upstream side of each of impedance matching boxes 31a, 31b, i.e., Pr shown in Fig. 4 does not return. Generally, reflected wave Pr can be suppressed to approximately 1 to 3% of the travelling wave Pf.

Under the above conditions, when the plasma is generated for a time of approximately, 4 to 6 minutes, i-type microcrystalline silicon film is deposited on a substrate 11. After the film deposition, the substrate 11 is taken out from the vacuum vessel 1, and the film thickness distribution of the i-type microcrystalline silicon film is evaluated.

The film thickness distribution of the i-type microcrystalline silicon film deposited on the substrate 11 becomes a sinusoidal distribution due to the standing wave which is a phenomenon unique to VHF plasma as will be explained later.

This film deposition test is conducted 5 or 6 times, for example, with a parameter of the phase difference of the two outputs of the 1st pulse-modulation, phase-adjustable, 2-output transmitter 25a.

In a direction connecting the 1st and 2nd feeding points 20a, 20b, the interval between the antinodes of the standing wave is measured. That is, the distance between a position of maximum film thickness of the i-type microcrystalline silicon film deposited on the substrate 11 and an adjacent position of maximum film thickness is measured.

This means that the interval is a value of one half of the wavelength $\lambda$ at the time of plasma generation of the power used.

Based on the above measurement results, the wavelength reduction rate of the power used and the setting = 1.65 m of the distance between the 1st and 2nd feeding points are evaluated.

Assuming that the interval between antinodes of the standing wave is 825 mm, the wavelength $\lambda$ = 825 mm x 2 = 1650 mm at the time of plasma generation of the power used. In this case, the wavelength reduction rate $\lambda/\lambda_o$ of the power used is determined to be

$$\lambda/\lambda_o = 1650 \text{ mm}/3000 \text{ mm} = 0.55$$

where $\lambda$ is the wavelength at the time of the plasma generation of the power used, and $\lambda_o$ is the wavelength in the vacuum of electromagnetic waves at a frequency of 100 MHz.

The setting of 1.65 m for the distance between the 1st and the 2nd feeding points is confirmed to match the value of the integer times one half of the wavelength $\lambda$ for which the wavelength reduction rate = 2 x $\lambda$/2 = 2 x 0.825 m is considered.

In the above measurement results, when the interval between the antinodes of the standing wave is different from 825 mm, for example, when the interval between the antinodes of the standing wave is 795 mm, the wavelength at the time of plasma generation of the power used is $\lambda$ = 795 mm x 2 = 1590 mm. In this case, the wavelength reduction rate $\lambda/\lambda_o$ of the power used is determined to be

$$\lambda/\lambda_o = 1590 \text{ mm}/3000 \text{ mm} = 0.53$$

where $\lambda$ is the wavelength at the time of plasma generation of the power used, and $\lambda_o$ is the wavelength in the vacuum of electromagnetic waves having a frequency of 100 MHz.

In this case, the setting = 1.65 m for the distance between the 1st and the 2nd feeding points does not match an integer multiple of one half of the wavelength $\lambda$ for which the wavelength reduction rate is considered. Therefore, the setting of 1.65 m must be changed to, for example, 1590 mm.

Alternatively, since 0.53 could be confirmed as the wavelength reduction rate $\lambda/\lambda_o$ of the power used, this data can be used, and the 100 MHz frequency may be changed to 96 MHz.

That is, if considering that the wavelength in the vacuum of electromagnetic waves having a frequency of 96 MHz is 3.125 m and the wavelength reduction rate $\lambda/\lambda_o$ of the power used is 0.53, the wavelength $\lambda$ at the frequency of 96 MHz at the time of plasma generation is $\lambda$ = 0.53 x 3.125 m = 1656 mm.

In Step 1, as explained above, the wavelength of the power used under the film deposition conditions of the i-type microcrystalline silicon film is measured. Then based on this data, the distance between 1st and 2nd feeding points 20a, 20b is confirmed to be an integer n times one half of the wavelength $\lambda$ during plasma generation of the power used. In addition, the wavelength reduction rate of the measured power used is confirmed.

When the distance between the 1st and 2nd feeding points 20a, 20b is not set to an integer n times one half of the wavelength $\lambda$ during plasma generation of the power used, the distance between 1st and 2nd feeding points 20a, 20b is set again so as to satisfy the conditions.

Alternatively, the frequency of the plasma generation power is changed so as to satisfy the above conditions.

To facilitate the explanation, we start from the position where the result of Step 1 has confirmed that the setting = 1.65 m for the distance between the 1st and the 2nd feeding points matched an integer multiple of one half of the wavelength $\lambda$ for which the wavelength reduction rate = 2 x $\lambda$/2 = 2 x 0.825 m is considered. The explanation follows. The frequency is 100 MHz.

[Step 2]

In Figs. 1 to 4, the substrate 11 is set on the 2nd electrode 4 in advance, and vacuum pump 10, which is not shown, is operated to remove the contaminated gas etc. in the vacuum vessel 1. Then the pressure is maintained at 5.0 Torr (665 Pa) while continuing to supply SiH4 gas through a raw material gas supply pipe 8 at 0.8 to 1.0 SLM (gas flow calculated in standard condition: L/minute), for example, 0.8 SLM, and hydrogen at 5.0 SLM. The substrate temperature is held in the range from 100°C to 350°C, for example, at 220°C.

The size of substrate 11 is set to 1.5-m length x 0.25-m width (4-mm thickness). The size smaller than the size of the 1st electrode is based on the empirical knowledge that there is occurrence of no reproducibility in the plasma intensity due to the edge effect at the ends of the electrode.

Next, when the frequency of the 1st and the 2nd powers is 100 MHz, pulse width Hw = 400 $\mu$sec, pulse period T0 = 1 msec, then a total power of 1 to 1.5 kW, for example, 1 kW, is supplied.

The phase difference between the two outputs of 1st pulse-modulation, phase-adjustable, 2-output transmitter 25a is set to, for example, zero, the pulse width Hw = 400 $\mu$sec and the pulse period T0 = 1 msec. The output of the 1st power amplifier 29a is set to 500 W and is supplied through the 1st impedance matching box 31a, 1st coaxial cable 32a, 1st current introduction terminal 33a, and 3rd coaxial cable 34a to 1st and 3rd feeding points 20a, 21a. The output of 2nd power amplifier 29b is set to 500 W, and is supplied through 2nd impedance matching box 31b, 2nd coaxial cable 32b, 2nd current introduction terminal 33b, and 4th coaxial cable 34b to the interval between 2nd and 4th feeding points 20b, 21b.

In this case, by adjusting the 1st impedance matching box 31a and 2nd impedance matching box 31b, it is possible ot establish a state where the reflected wave of the supplied power does not return to the upstream side of each of impedance matching boxes 31a, 31b, i.e., Pr shown in Fig. 4 does not return. Generally, reflected wave Pr can be suppressed to approximately 1 to 3% of the travelling wave Pf.

Under the above conditions, when the plasma is generated for a time of approximately 4 to 6 minutes, i-type microcrystalline silicon film is deposited on the substrate 11. The film thickness distribution of the i-type microcrystalline silicon film deposited on the substrate 11 becomes a sinusoidal distribution due to the generation of standing waves which is a phenomenon unique to VHF plasma as will be explained below.

The voltage wave of the 1st power supplied in the pulse form through the 1st and 3rd feeding points 20a, 21a and the voltage wave of the 2nd power supplied in the pulse form through 2nd and 4th feeding points 20b, 21b are oscillated from the same power supply and are propagated in counter-direction opposing each other in a space between the electrodes. In other words, the two waves are propagated from mutually opposite directions and overlap to generate an interference phenomenon.

In Fig. 3, let the distance in the direction from the 1st feeding point 20a side to the 2nd feeding point 20b be x, then the standing wave transmitted in the positive direction of x is W11(x, t), and the standing wave transmitted in the negative direction of x, that is, the standing wave transmitted from the 2nd feeding point 21a [*sic,* 20b] side to the 1st feeding point 20a, is W12(x, t), and are expressed as follows.

$$W11(t) = V1 \bullet \sin(\omega t + 2\pi x/\lambda)$$

$$W12(t) = V1 \bullet \sin\{\omega t - 2\pi(x - L0)/\lambda + \Delta\theta\}$$

where V1 is the amplitude of the voltage wave; $\omega$, the angular frequency of the voltage; $\lambda$, the wavelength of the voltage wave; t, the time; L0, the interval between the 1st and the 2nd feeding points; and $\Delta\theta$, the phase difference of the voltage wave of the 1st power and the voltage wave of the 2nd power. The composite wave W1(x, t) of the two standing waves becomes the following equation.

$$W1(x, t) = W11(x, t) + W12(x, t)$$
$$= 2 \bullet V1 \cos\{2\pi(x - L0/2)/\lambda - \Delta\theta/2\} \bullet \sin\{\omega t + (\pi L0/\lambda + \Delta\theta/2)\}$$

The composite wave W1(x, t) has the properties described below. When $\Delta\theta = 0$, the intensity of the generated plasma is stronger in the centre section (x = L0/2) between the feeding points and becomes weaker when moving away from the centre section. When $\Delta\theta > 0$, the strong part of the plasma migrates toward one feeding point side, and when $\Delta\theta < 0$, the strong part of the plasma migrates toward the other feeding point side.

Here, a composite wave of the two standing waves of W11(x, t) and W12(x, t) is called the 1st standing wave W1(x, t).

The intensity of the power between a pair of electrodes is proportional to the square of the amplitude of the composite wave W1(x, t) of the voltage. The intensity I1(x, t) of the power is expressed by:

$$I1(x, t) \propto \cos^2\{2\pi(x - L0/2)/\lambda - \Delta\theta/2\}$$

I1(x, t) is illustrated conceptually (schematically) as a solid line in Fig. 7 (intensity distribution of the 1st standing wave).

After film deposition under the above conditions, the substrate 11 is taken out from the vacuum vessel 1, and the film thickness distribution of the i-type microcrystalline silicon film is evaluated.

As described earlier, the film thickness distribution of the i-type microcrystalline silicon film deposited on substrate 11 becomes a sinusoidal distribution due to the generation of standing waves which is a phenomenon unique to VHF plasma. The film deposition test is conducted repeatedly with a parameter of phase difference of the two outputs of 1st pulse-modulation, phase-adjustable, 2-output transmitter 25a.

In the direction connecting 1st and 2nd feeding points 20a, 20b, the relationship between the distance from the centre point of substrate 11 to the position of the maximum thickness in the sinusoidal film thickness distribution and a phase difference between the two outputs of the 1st pulse-modulation, phase-adjustable, 2-output transmitter 25a is determined as data.

For example, when the position of a dashed line in Fig. 8A is at the centre point of substrate 11, the phase difference to match the centre point to the position of the maximum thickness of the sinusoidal film thickness distribution is found to be, for example, $\Delta\theta1$.

The sinusoidal film thickness distribution shown in Fig. 8A shows the intensity distribution of the 1st standing wave W1 (x, t), that is, the distribution proportional to

$$I1(x, t) \propto \cos^2\{2\pi(x - L0/2)/\lambda - \Delta\theta/2\}$$

This state shows the presence of an antinode of the 1st standing wave at the centre and the presence of the antinodes at the positions of 1st and the 2nd feeding points 20a, 20b.

That is, the distance between 1st and 2nd feeding points 20a, 20b is set to an integer n times one half of the wavelength λ, i.e., nλ/2, of the power used that considered the wavelength reduction rate. Thus, adjustment method in which the antinode of the 1st standing wave is matched to the centre point between 1st and 2nd feeding points 20a, 20b is identical to the adjustment method in which the antinodes of the 1st standing wave is matched to the positions of 1st and 2nd feeding points 20a, 20b.

In addition, the distance between 1st and 2nd feeding points 20a, 20b is set to an integer n times one half of the wavelength λ, i.e., nλ/2, of the power used for which the wavelength reduction rate is considered. The adjustment method that matches the node of the 1st standing wave to the centre point between 1st and 2nd feeding points 20a, 20b is identical to the adjustment method that matches the nodes of the 1st standing wave to the positions of 1st and 2nd feeding points 20a, 20b.

When film is deposited with a sinusoidal film thickness distribution, each of the distance between 1st and 2nd feeding points 20a, 20b and the distance between 1st and 2nd [*sic,* 3rd and 4th] feeding points 21a, 21b matches an integer multiple of one half of the wavelength λ for which the wavelength reduction rate is considered. In addition, because the position is at the end of the pair of electrodes, the resonance phenomenon appears in which standing waves are easily generated where both ends of the pair of electrodes are the antinodes or the nodes.

This resonance phenomenon, as described above, means that the generation of stable plasma is easy, and the action which effectively consumes the supplied power in the plasma generation is present.

[Step 3]

In Fig. 1 to Fig. 4, the substrate 11 is positioned on the 2nd electrode 4 beforehand and a vacuum pump 10, which is not shown, is operated to remove the contaminated gas in vacuum vessel 1. Then the pressure is maintained at 5.0 Torr (665 Pa) while continuing to supply SiH4 gas through the raw material gas supply pipe 8 at 0.8 to 1.0 SLM (gas flow calculated in standard condition: L/minute), for example, 0.8 SLM, and hydrogen at 5.0 SLM. The substrate temperature is held in the range from 100°C to 350°C, for example, at 220°C.

The size of substrate 11 is set to 1.5-m length x 0.25 m-width (4-mm thick). The size smaller than the size of the 1st electrode is based on the empirical knowledge that there is occurrence of no reproducibility in the plasma intensity due to the edge effect at the ends of the electrode.

Next, when the frequency of the 3rd and the 4th powers is 100 MHz, pulse width Hw = 400 μsec, pulse period T0 = 1 msec, then a total power of 1 to 1.5 kW, for example, 1 kW, is supplied.

The phase difference between the two outputs of the 2nd pulse-modulation, phase-adjustable, 2-output transmitter 25b is set to, for example, zero, the pulse width Hw = 400 μsec and the pulse period T0 = 1 msec. The output of 1st power amplifier 29a is set to 500 W. The output thereof is supplied through 1st impedance matching box 31a, 1st coaxial cable 32a, 1st current introduction terminal 33a, and 3rd coaxial cable 34a to 1st and 3rd feeding points 20a, 21a. The output of 2nd power amplifier 29b is set to 500 W. The output thereof is supplied through the 2nd impedance matching box 31b, 2nd coaxial cable 32b, 2nd current introduction terminal 33b, and 4th coaxial cable 34b to the interval between 2nd and 4th feeding points 20b, 21b.

In this case, by adjusting the 1st impedance matching box 31a and 2nd impedance matching box 31b, it is possible to establish a state where the reflected wave of the supplied power does not return to the upstream side of each of impedance matching boxes 31a, 31b, i.e., Pr shown in Fig. 4 does not return. Generally, reflected wave Pr can be suppressed to approximately 1 to 3% of the travelling wave Pf.

Under the above conditions, when the plasma is generated for a time of approximately 4 to 6 minutes, i-type microcrystalline silicon film is deposited on substrate 11. The film thickness distribution of the i-type microcrystalline silicon film deposited on substrate 11 becomes a sinusoidal distribution due to the generation of standing waves which is a phenomenon unique to VHF plasma as will be explained below.

The voltage wave of the 3rd power supplied in pulse form through 1st and 3rd feeding points 20a, 21a and the voltage wave of the 4th power supplied in pulse form through 2nd and 4th feeding points 20b, 21b are oscillated from the same power supply and are transmitted in opposition between the electrodes. In other words, the two waves are propagated from mutually opposite directions and overlap to generate an interference phenomenon.

In Fig. 3, let the distance in the direction from the 1st feeding point 20a side to the 2nd feeding point 20b be x, then the standing wave propagated in the positive direction of x is W21(x, t), and the standing wave transmitted in the negative direction of x, that is, the standing wave transmitted from the 2nd feeding point 20b side to the 1st feeding point 20a, is W22(x, t), and are expressed as follows.

$$W21(x, t) = V1 \bullet \sin(\omega t + 2\pi x/\lambda)$$

$$W22(t) = V1 \bullet \sin\{\omega t - 2\pi(x - L0)/\lambda + \Delta\theta\}$$

where V1 is the amplitude of the voltage wave; $\omega$, the angular frequency of the voltage; $\lambda$, the wavelength of the voltage wave; t, the time; L0, the interval between the 1st and the 2nd feeding points; and $\Delta\theta$, the phase difference of the voltage wave of the 3rd power and the voltage wave of the 4th power. The composite wave W2(x, t) of the two standing waves becomes the following equation.

$$W2(x, t) = W21(x, t) + W22(x, t)$$
$$= 2 \bullet V1 \cos\{2\pi(x - L0/2)/\lambda - \Delta\theta/2\} \bullet \sin\{\omega t + (\pi L0/\lambda + \Delta\theta/2)\}$$

The composite wave W2(x, t) has the properties described below. When $\Delta\theta = 0$, the intensity of the generated plasma is stronger in the centre section (x = L0/2) between the feeding points and becomes weaker when moving away from the centre section. When $\Delta\theta > 0$, the strong part of the plasma moves toward one feeding point side, and when $\Delta\theta < 0$, the strong part of the plasma moves toward the other feeding point side.

Here, the composite wave of the two standing waves of W21(x, t) and W22(x, t) is called the 2nd standing wave W2(x, t).

The intensity of the power between the pair of electrodes is proportional to the square of the amplitude of the composite wave W2(x, t) of the voltage. The intensity 12(x, t) of the power is expressed by:

$$I2(x, t) \propto \cos^2\{2\pi(x - L0/2)/\lambda - \Delta\theta/2\}$$

12(x, t) is illustrated conceptually (schematically) as the dashed line in Fig. 7 (intensity distribution of the 2nd standing wave).

After film deposition under the above conditions, substrate 11 is taken out from vacuum vessel 1, and the film thickness distribution of the i-type microcrystalline silicon film is evaluated.

As described earlier, the film thickness distribution of the i-type microcrystalline silicon film deposited on substrate 11 becomes a sinusoidal distribution due to the generation of standing waves which is a phenomenon unique to VHF plasma. The film deposition test is conducted repeatedly with a parameter of the phase difference of the two outputs of 2nd pulse-modulation, phase-adjustable, 2-output transmitter 25b.

In the direction connecting 1st and 2nd feeding points 20a, 20b, the relationship between the distance from the centre point of substrate 11 to the position of the maximum thickness in the sinusoidal film thickness distribution and the phase difference between the two outputs of 1st [*sic,* 2nd] pulse-modulation, phase-adjustable, 2-output transmitter 25b is found as data.

For example, when the position of the broken line in Fig. 8B is at the centre point of substrate 11, the phase difference to set at the position a quarter of the wavelength $\lambda$ in the direction from the centre point toward 2nd feeding point 20a [*sic,* 20b] is found to be, for example, $\Delta\theta2$. From the measurement result in Step 1, $\lambda/4$ = 413 mm.

Alternatively, when the position of the dashed line in Fig. 8B is at the centre point of substrate 11, the phase difference to match the centre point thereof to the position of the minimum thickness of the sinusoidal film thickness distribution is found to be, for example, $\Delta\theta2$.

The sinusoidal film thickness distribution shown in Fig. 8B shows the intensity distribution of the 2nd standing wave W2 (x, t), that is, the distribution proportional to:

$$I2(x, t) \propto \cos^2\{2\pi(x - L0/2)/\lambda - \Delta\theta/2\}$$

This state shows the node of the 2nd standing wave at the centre and the nodes at the positions of 1st and 2nd feeding points 20a, 20b.

The distance between 1st and 2nd feeding points 20a, 20b is set to an integer n times one half of the wavelength $\lambda$, i.e.,

$n\lambda/2$, of the power used for which the wavelength reduction rate is considered. The adjustment method that matches the node of the 2nd standing wave to the centre point between 1st and 2nd feeding points 20a, 20b is identical to the adjustment method that matches the nodes of the 2nd standing wave to the positions of 1st and 2nd feeding points 20a, 20b.

When film is deposited with a sinusoidal film thickness distribution, each of the distance between 1st and 2nd feeding points 20a, 20b and the distance between 1st and 2nd [*sic,* 3rd and 4th] feeding points 21a, 21b matches an integer multiple of one half of the wavelength $\lambda$ for which the wavelength reduction rate is considered. In addition, because the position is the end of the pair of electrodes, the resonance phenomenon appears in which standing waves are easily generated where both ends of the pair of electrodes are the antinodes or the nodes.

This resonance phenomenon, as described above, means that the generation of stable plasma is easy, and the action that effectively consumes the supplied power in the plasma generation is present.

[Step 4]

After the results of Steps 1 to 3 above are obtained, a step of depositing the target i-type microcrystalline silicon film is entered. First, in Fig. 1 to Fig. 4, a substrate 11 is positioned on the 2nd electrode 4 beforehand and a vacuum pump 10, which is not shown, is operated to remove the contaminated gas in the vacuum vessel 1. Then the pressure is maintained at 5.0 Torr (665 Pa) while continuing to supply SiH4 gas through a raw material gas supply pipe 8 at 0.8 to 1.0 SLM (gas flow calculated in standard condition: L/minute), for example, 0.8 SLM, and hydrogen at 5.0 SLM. The substrate temperature is held in the range from 100°C to 350°C, for example, at 220°C.
The size of substrate 11 is set to 1.5-m length x 0.25-m width (4-mm thick).
Next, the phase difference of the two outputs of the 1st pulse-modulation, phase-adjustable, 2-output transmitter 25a, the sinusoidal waves having a frequency of 100 MHz, is set to $\Delta\theta1$ determined from the data obtained in Step 2. The pulse modulation is set as follows: the pulse width Hw and the pulse period T0 in W11(t) and W12(t) shown in Figs. 5 and 6 to, for example, Hw = 400 $\mu$sec and T0 = 1 msec. The 1st and 2nd powers are supplied as 500 W to 1st and 3rd feeding points 20a, 21a and 2nd and 4th feeding points 20b, 21b, respectively.
The phase difference between the two outputs of the 2nd pulse-modulation, phase-adjustable, 2-output transmitter 25b, namely, the sinusoidal waves having the frequency of 100 MHz, is set to $\Delta\theta2$ determined from the data obtained in Step 3. In addition, the pulse modulation is set to the pulse width Hw and the pulse period T0 in W21(t) and W22(t) shown in Figs. 5 and 6, for example, pulse width Hw = 400 $\mu$sec and the pulse period T0 = 1 msec, and a half period from the pulse rising time of the pulse modulation of W11(t) and W12(t), namely, to rise at a time delayed by TO/2, is set. The 3rd and 4th powers are each 500 W and are supplied to 1st and 3rd feeding points 20a, 21a and to 2nd and 4th feeding points 20b, 21b.
The Hw, T0, and pulse rising time of the pulse modulation are changed from the above numerical values, and the film is deposited, and several sets of film deposition data can be compared.
When the four powers are supplied between the pair of electrodes 2, 4, as described previously, W11(x, t) and W12(x, t) interfere to form 1st standing wave W1(x, t). W21(x, t) and W22(x, t) interfere to form 2nd standing wave W2(x, t). However, W11(x, t) does not interfere because W21(x, t) and W22(x, t) are separated with respect to time. Similarly, W12(x, t) does not interfere with W21(x, t) and W22(x, t).
Consequently, if the general film deposition time of at least several seconds which is much longer than the period T0 of the pulse modulation is considered, the intensity distribution of the power generated between the pair of electrodes 2, 4 is formed to overlap the intensity distribution I1(x, t) of 1st standing wave W1(x, t) and the intensity distribution I2(x, t) of 2nd standing wave W2(x, t). Fig. 7 conceptually (schematically) shows this aspect.
When the centre point of the substrate is the origin of the x axis, the direction from the 1st feeding point 20a side to the 2nd feeding point 20b is set as a positive direction. The intensity distribution I1(x, t) of 1st standing wave W1(x, t) is

$$I1(x, t) = A\cos^2\{2\pi x/\lambda\}$$

where A is the proportionality constant.
The intensity distribution I2(x, t) of 2nd standing wave W2(x, t) is

$$I2(x, t) = A\sin^2\{2\pi x/\lambda\}$$

The intensity distribution I(x, t) of the power generated between the pair of electrodes 2, 4 is

$$I(x, t) = A\cos^2\{2\pi x/\lambda\} + A\sin^2\{2\pi x/\lambda\} = A$$

This result shows that the intensity distribution I(x, t) of the power generated between the pair of electrodes 2, 4 is a constant value that does not depend on x, that is, the position in the transmission direction of the power, and is uniform. In addition, the intensity is shown to be independent of the frequency and becomes uniform.

The above plasma generation method can be said to be a method that is not affected by the standing waves, that is, a plasma generation method free of standing waves.

When SiH4 gas is formed into plasma, radicals such as SiH3, SiH2, SiH, H present in the plasma are dispersed by the dispersion phenomenon and adhered to the surface of substrate 11 to deposit i-type microcrystalline silicon film. As described above, the distribution of power between the pair of electrodes 2, 4 is uniform on average over time, and the deposited film becomes uniform.

In the apparatus and method of the present invention, a uniform film thickness distribution can be formed even when the target is a substrate having a size exceeding one half of the wavelength λ. This means that even when the target is a substrate having a size exceeding one half of the wavelength λ that is regarded as impossible in the conventional VHF plasma surface treatment apparatus and method, the present invention can form a uniform film thickness distribution.

In addition, each of the distance between 1st and 2nd feeding points 20a, 20b and the distance between 3rd and 4th feeding points 21a, 21b matches an integer multiple of one half of the wavelength λ for which the wavelength reduction rate is considered. Because the position of the mode or antinode is at the end of the pair of electrodes, standing waves are generated easily where both ends of the pair of electrodes are the antinodes or the nodes.

These features mean that in addition to the ease of stable plasma generation, the supplied power is effectively consumed in the plasma generation.

Consequently, the above is a breakthrough discovery in the application field of VHF plasma CVD apparatuses. Their practical value is immense.

The film deposition rate of the i-type microcrystalline silicon film deposited in Step 4 obtains approximately 3.0 to 3.5 nm/s at the supplied power density 4 kW/m$^2$ (2 kW/0.495 m$^2$).

In addition, at the supplied power density of 3.23 kW/m$^2$ (1.6 kW/0.495 m$^2$), approximate value of 2.5 to 2.8 nm/s is obtained.

The supplied power density of 4 kW/m$^2$ (2 kW/0.495 m$^2$) for the film deposition rate of 3.0 to 3.5 nm/s and the supplied power density of 3.23 kW/m$^2$ (1.6 kW/0.495 m$^2$) for a film deposition rate of about 2.5 to 2.8 nm/s are small numerical values compared to the supplied power density in the conventional technologies.

This means that due to the action of the resonance phenomenon described above, a power supply is realised that suppresses the power losses when power is supplied to the pair of electrodes.

In the first exemplary embodiment of the present invention, because the size of the 1st electrode is 1.65 m x 0.3 m (20-mm thickness) and the size of the 2nd electrode is 1.65 m x 0.4 m (150-mm thickness), the substrate size is limited to approximately 1.5 m x 0.25 m x 4-mm thickness. However, if the number of the 1st electrodes 2 increases, the size of the 2nd electrode increases, and the same number of power supply apparatuses (power supply system shown in Fig. 1) as the 1st electrodes 2 is set up, naturally, the width of the substrate can be expanded.

In addition, in the manufacture of an integrated tandem thin-film silicon solar cell, if the film thickness distribution is within ±10%, there are no problems in performance. According to the above embodiment, even if a 100-MHz power source frequency is used, uniformity is possible in the intensity distribution I(x, t) of the power between the pair of electrodes 2, 4 which was not possible with the conventional technologies. In other words, the film thickness distribution can be realised within ±10%.

This means that the engineering value is significant in relation to the improved productivity and the lowering in costs in the manufacturing fields of thin-film silicon solar cells, thin-film transistors, and light exposure drum and the like.

Example 2

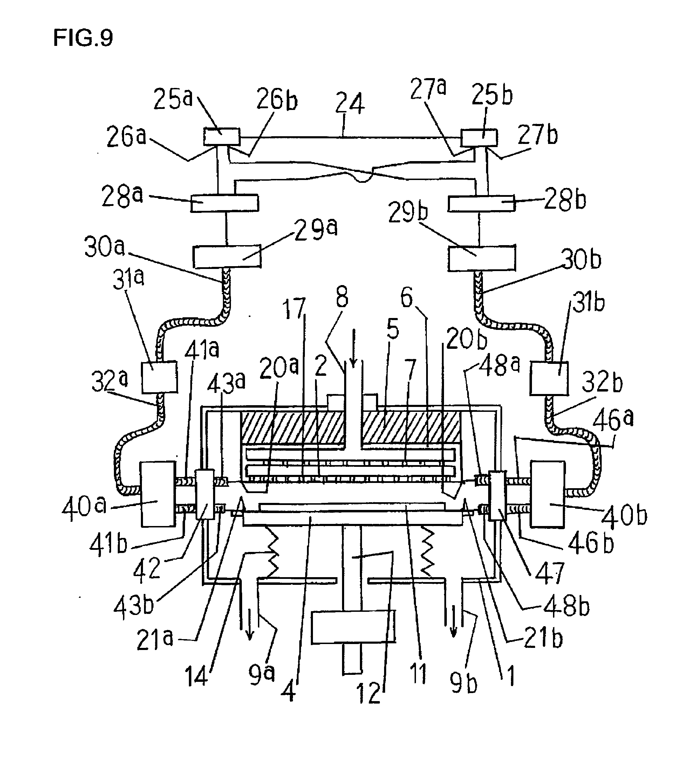

Next, the plasma CVD apparatus and the plasma CVD method related to the second exemplary embodiment of the present invention are explained with reference to Figs. 9 to 11.

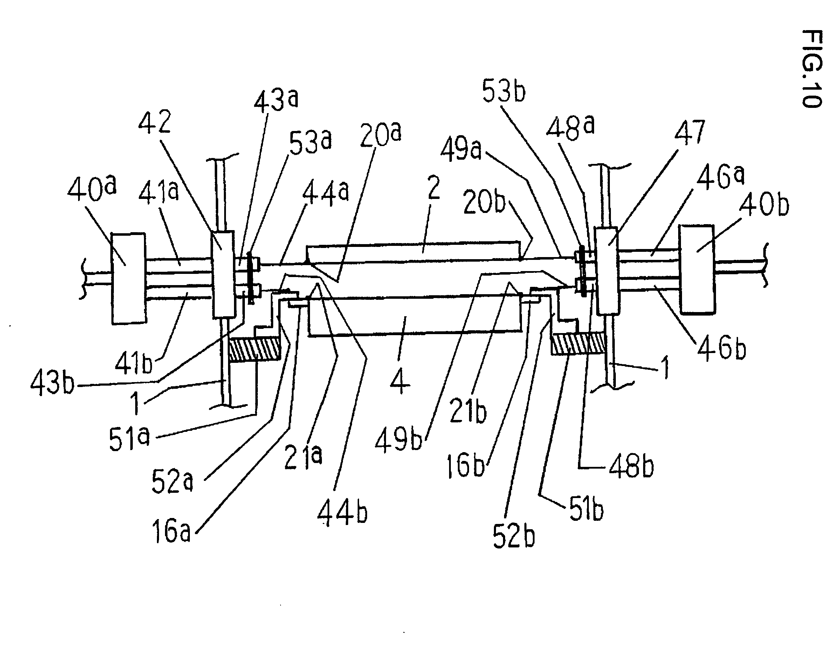

Fig. 9 is an explanatory drawing showing the entire plasma CVD apparatus related to the second exemplary embodiment of the present invention. Fig. 10 is an explanatory drawing of the power supply apparatus to the pair of electrodes that uses a balanced-to-unbalanced converter in the plasma CVD apparatus shown in Fig. 2. Fig. 11 is an explanatory drawing of the flow of the high-frequency current in the power supply apparatus to the pair of electrodes that used the balanced-to-unbalanced converter shown in Fig. 10.

First, the constitution of the apparatus is explained. However, parts which are the same parts indicated in the plasma CVD apparatus related to the first embodiment of the present invention described above are assigned the same reference numbers, and their explanations are omitted.

Initially, an overview of the apparatus is explained. The constitution of the apparatus related to the second exemplary embodiment of the present invention is identical overall to the apparatus shown in Fig. 1 in the first exemplary embodiment. In the apparatus constitution shown in Figs 9 and 10, a balanced-to-unbalanced converter comprised of an LC bridge balanced-to-unbalanced converter and balanced transmission lines is inserted between 1st impedance matching box 31a and 1st and 3rd feeding points 20a, 21a, and between 2nd impedance matching box 31b and the 2nd and 4th feeding points 20b, 21b.

When a balanced-to-unbalanced converter comprised of an LC bridge balanced-to-unbalanced converter and balanced transmission lines is inserted, as disclosed in Patent Document 5, high-frequency power can be supplied only between the pair of electrodes while suppressing the generation of leakage current as shown in Fig. 13, and an effective means capable of suppressing wasteful power consumption results.

In Figs. 9 and 10, the feeding points positioned where the high-frequency power is fed to the pair of electrodes 2, 4 are both ends of the electrodes at opposite positions in the transmission of the high-frequency power wave, similar to the apparatus related to the first exemplary embodiment of the present invention. First feeding point 20a and 2nd feeding point 20b are arranged on the 1st electrode 2. Then, 3rd feeding point 21a and 3rd [*sic,* 4th] feeding point 21b are arranged on 2nd electrode 4.

The interval between 1st and 2nd feeding points 20a, 20b is set to an integer n times one half of the wavelength $\lambda$, i.e., $n\lambda/2$, of the power used for which the wavelength reduction rate is considered. Similarly, the interval between 3rd and 4th feeding points 21a, 21b is set to an integer n times one half of the wavelength $\lambda$, i.e., $n\lambda/2$, of the power used for which the wavelength reduction rate is considered.

As in the plasma CVD apparatus related to the first exemplary embodiment of the present invention, the interval between 1st and 2nd feeding points 20a, 20b and the interval between 3rd and 4th feeding points 21a, 21b are set to 1.65 m, respectively.

The frequency of the power used is set to, for example, 100 MHz, then the wavelength reduction rate $\lambda/\lambda_o$ is expected to be 0.6 (namely, $\lambda = 0.55 \times 3$ m) , and $n\lambda/2 = 2 \times 1.65$ m/2 = 1.65 m.

The $\lambda$ is the wavelength during plasma generation of the power used, and $\lambda_o$ is the wavelength in a vacuum of electromagnetic waves having a 100 MHz frequency.

In Figs. 9 and 10, the constitution of the apparatus that generates the 1st standing wave is as follows.

One of the two outputs of 1st pulse-modulation, phase-adjustable, 2-output transmitter 25a, that is, the output signal of output terminal 26a, is supplied to 1st and 3rd feeding points 20a, 21a through 1st coupler 28a; 1st amplifier 29a; coaxial cable 30a; 1st impedance matching box 31a; 1st coaxial cable 32a; 1st LC bridge balanced-to-unbalanced converter 40a; 5th and 6th coaxial cables 41a, 41b connected respectively to the two output terminals of 1st LC bridge balanced-to-unbalanced converter 40a; 7th and 8th coaxial cables 43a, 43b connected respectively through 3rd current introduction terminal 42 to 5th and 6th coaxial cables 41a, 41b; and core lines 43a, 43b [sic. 44a, 44b] of 7th and 8th coaxial cables 43a, 43b.

As shown in Fig. 10, core line 44b of 8th coaxial cable 43b uses insulating part 51a and connecting part 52a to connect to the 3rd feeding point. In addition, the outer conductors of 7th and 8th coaxial cables 43a, 43b are short circuited by a 1st outer conductor fitting 53a.

The output signal of output terminal 26a of the 1st pulse-modulation, phase-adjustable, 2-output transmitter 25a is amplified by the 1st amplifier 29a. The power supplied through the 1st impedance matching box 31a and the 1st LC bridge balanced-to-unbalanced converter 40a to 1st and 3rd feeding points 20a, 21a is called the 1st power, similar to the apparatus related to the first exemplary embodiment of the present invention.

The other of the two outputs of the 1st pulse-modulation, phase-adjustable, 2-output transmitter 25a, that is, the output signal of output terminal 26b, is supplied to 2nd and 4th feeding points 20b, 21b through the 2nd coupler 28b; 2nd amplifier 29b; coaxial cable 30b; 2nd impedance matching box 31b; 2nd coaxial cable 32b; 2nd LC bridge balanced-to-unbalanced converter 40b; 9th and 10th coaxial cables 46a, 46b connected respectively to the two output terminals of 2nd LC bridge balanced-to-unbalanced converter 40b; 11th and 12th coaxial cables 48a, 48b connected respectively through 4th current introduction terminal 47 to 9th and 10th coaxial cables 46a, 46b; and core lines 49a, 49b of 11th and 12th coaxial cables 48a, 48b.

As shown in Fig. 10, core line 49b of 12th coaxial cable 48b uses insulating part 51b and connecting part 52b to connect to 4th feeding point 21b. In addition, the outer conductors of 11th and 12th coaxial cables 48a, 48b are short circuited by a 2nd outer conductor fitting 53b.

The output signal of output terminal 26b of the 1st pulse-modulation, phase-adjustable, 2-output transmitter 25a is amplified by the 2nd amplifier 29b. The power supplied through 2nd impedance matching box 31b and 2nd LC bridge balanced-to-unbalanced converter 40b to 2nd and 4th feeding points 20b, 21b is called the 2nd power, similar to the apparatus related to the first exemplary embodiment of the present invention.

In Figs. 9 and 10, the constitution of the apparatus that generates the 2nd standing wave is as follows.

One of the two outputs of the 2nd pulse-modulation, phase-adjustable, 2-output transmitter 25b, that is, the output signal of output terminal 27a, is supplied to 1st and 3rd feeding points 20a, 21a through 1st coupler 28a; 1st amplifier 29a; coaxial cable 30a; 1st impedance matching box 31a; 1st coaxial cable 32a; 1st LC bridge balanced-to-unbalanced converter 40a; 5th and 6th coaxial cables 41a, 41b connected respectively to the two output terminals of 1st LC bridge balanced-to-unbalanced converter 40a; 7th and 8th coaxial cables 43a, 43b connected respectively through 3rd current introduction terminal 42 to 5th and 6th coaxial cables 41a, 41b; and core lines 43a, 43b of 7th and 8th coaxial cables 43a, 43b.

As shown in Fig. 10, core line 44b of 8th coaxial cable 43b uses insulating part 51a and connecting part 52a to connect to the 3rd feeding point. In addition, the outer conductors of 7th and 8th coaxial cables 43a, 43b are short circuited by 1st outer conductor fitting 53a.

The output signal of output terminal 27a of 2nd pulse-modulation, phase-adjustable, 2-output transmitter 26a [sic.25b] is amplified by 1st amplifier 29a. The power supplied through 1st impedance matching box 31a and 1st LC bridge balanced-to-unbalanced converter 40a to 1st and 3rd feeding points 20a, 21a is called the 3rd power, similar to the apparatus related to the first exemplary embodiment of the present invention.

The other of the two outputs of the 2nd pulse-modulation, phase-adjustable, 2-output transmitter 26a [*sic,* 25b], that is, the output signal of output terminal 27b, is supplied to 2nd and 4th feeding points 20b, 21b through 2nd coupler 28b; 2nd amplifier 29b; coaxial cable 30b; 2nd impedance matching box 31b; 2nd coaxial cable 32b; 2nd LC bridge balanced-to-unbalanced converter 40b; 9th and 10th coaxial cables 46a, 46b connected respectively to the two output terminals of 2nd LC bridge balanced-to-unbalanced converter 40b; 11th and 12th coaxial cables 48a, 48b connected respectively through 4th current introduction terminal 47 to 9th and 10th coaxial cables 46a, 46b; and core lines 49a, 49b of 11th and 12th coaxial cables 48a, 48b.

As shown in Fig. 10, core line 49b of 12th coaxial cable 48b uses insulating part 51b and connecting part 52b to connect to 4th feeding point. In addition, the outer conductors of 11th and 12th coaxial cables 48a, 48b are short circuited by 2nd outer conductor fitting 53b.

The output signal of output terminal 27b of the 2nd pulse-modulation, phase-adjustable, 2-output transmitter 25b is amplified by 2nd amplifier 29b. The power supplied through 2nd impedance matching box 31b and 2nd LC bridge balanced-to-unbalanced converter 40b to 2nd and 4th feeding points 20b, 21b is called the 4th power, similar to the apparatus related to the first exemplary embodiment of the present invention.

The action is explained so that the interval between the 1st feeding point 20a and 2nd feeding point 20b, and the interval between 3rd feeding point 21a and 4th feeding point 21b are each set to an integer n times one half of the wavelength $\lambda$, i.e., $n\lambda/2$, of the power used for which the wavelength reduction rate is considered.

When the 1st power is supplied through 1st and 3rd feeding points 20a, 21a to the pair of electrodes 2, 4, the power wave is transmitted as travelling wave from the 1st feeding point 20a side to the 2nd feeding point 20b side. Then, when the power wave arrives at the end of the pair of electrodes installed with 2nd and 4th feeding points 20b, 21b, the end forms an impedance discontinuity, and reflections occur at that end. The reflected wave transmits in the direction from the 2nd feeding point 20b to the 1st feeding point 20a.

If the travelling wave of the 1st power would be not reflected by the end of the pair of electrodes installed with 2nd and 4th feeding points 20b, 21b, the travelling wave will be transmitted through 2nd LC bridge balanced-to-unbalanced converter 40b and 2nd coaxial cable 32b and arrives at the 2nd impedance matching box 31b, and is then reflected back by the 2nd impedance matching box 31b. In this case, the problem is that there is consumption of power between the 2nd feeding point 20b and 2nd impedance matching box 31b, that is, the remaining problem is the power consumption other than the plasma generation between the pair of electrodes 2, 4.

Standing waves are generated by the interference phenomenon in which the travelling wave of the power supplied from the 1st feeding point 20a side and the reflected wave reflected at the ends of the pair of electrodes on the 2nd feeding point 20b side overlap. In this case, the distance between the supply point of the travelling wave and the generation point of the reflected wave is set to an integer n times one half of the wavelength $\lambda$, i.e., $n\lambda/2$, of the power used for which the wavelength reduction rate is considered. The phenomenon appears in which the antinodes of the generated standing waves are readily generated at the supply point of the travelling wave and the generation point of the reflected wave. Similarly, the phenomenon appears in which the nodes of the generated standing waves are readily generated at the supply point of the travelling wave and the generation point of the reflected wave. This phenomenon resembles the resonance phenomenon found in the acoustic engineering field.

The action of reducing consumption other than between the pair of electrodes is created by a phenomenon resembling the resonance phenomenon of the travelling wave of the 1st power and the reflected wave thereof. This action suppresses, to a minimum, the power losses in the power supply line destined to the pair of electrodes.

Similarly, when the 2nd power is supplied through 2nd and 4th feeding points 20b, 21b to pair of electrodes 2, 4, the power wave is transmitted as the travelling wave from the 2nd feeding point 20b side to the 1st feeding point 20a side. Then, when the power wave arrives at the ends of the pair of electrodes installed with 1st and 3rd feeding points 20a, 21a, the end forms an impedance discontinuity, therefore, reflections occur at the end. The reflected wave is transmitted in the direction from 1st feeding point 20a to 2nd feeding point 20b.

If the travelling wave of the 2nd power would be not reflected by the end of the pair of electrodes installed with 1st and 3rd feeding points 20a, 21a, the travelling wave will be transmitted through 1st LC bridge balanced-to-unbalanced converter 40a and 1st coaxial cable 32a and arrive at 1st impedance matching box 31a, and is then reflected back by the 1st impedance matching box 31a. In this case, the problem is the consumption of power between the 1st feeding point 20a and the 1st impedance matching box 31a, that is, the remaining problem is the power consumption other than the plasma generation between the pair of electrodes 2, 4.

Standing waves are generated by the interference phenomenon in which the travelling wave and the reflected wave reflected at the ends of the pair of electrodes on the 1st feeding point 20a side overlap. In this case, the distance between the supply point of the travelling wave and the generation point of the reflected wave is set to an integer n times one half of the wavelength $\lambda$, i.e., $n\lambda/2$, of the power used for which the wavelength reduction rate is considered. The phenomenon appears in which the antinodes of the generated standing waves are readily generated at the supply point of the travelling wave and the generation point of the reflected wave. Similarly, the phenomenon appears in which the nodes of the generated standing waves are readily generated at the supply point of the travelling wave and the generation point of the reflected wave. This phenomenon resembles the resonance phenomenon found in the acoustic engineering field.

The action of reducing consumption other than between the pair of electrodes is created by a phenomenon resembling the resonance phenomenon of the travelling wave of the 2nd power and the reflected wave thereof. This action suppresses, to the minimum, the power losses in the power supply line to the pair of electrodes.

In the supply of 3rd and 4th powers, as described above, also, there is the action in which the power losses in the power supply lines to the pair of electrodes are suppressed to the minimum by a phenomenon resembling the resonance phenomenon of the travelling waves of the 3rd and 4th powers and the reflected waves thereof.

Next, the method that uses the plasma CVD apparatus having the above constitution to deposit i-type microcrystalline silicon film for integrated tandem thin-film silicon solar cell is explained.

In the deposition of i-type microcrystalline silicon film, the raw material gas, pressure, density of the power to be applied, and substrate temperature are known, for example, the conditions described in Patent Document 1 and Non-Patent Document 1 are adopted.

However, it is required to confirm and adjust the unique conditions related to the plasma CVD apparatus having the above constitution, in advance, by the procedure shown below. Then, the film deposition of the target i-type microcrystalline silicon film is performed.

[Step 1] In the deposition of the target i-type microcrystalline silicon film, the knowledge about the raw material gas, pressure, density of the power to be applied, and the substrate temperature is adopted. Under those conditions, the wavelength $\lambda$ of the power transmitted between the pair of electrodes 2, 4 is measured. Based on this measurement data, the distance between the 1st and 2nd feeding points 20a, 20b is confirmed to be set to an integer n times one half of the wavelength $\lambda$, i.e., $n\lambda/2$, of the power.

[Step 2] The data required in the adjustment of the antinode positions of the 1st standing wave generated when the 1st and the 2nd powers are supplied to the pair of electrodes 2, 4 are determined. Specifically, the relationship between the setting value of the phase difference of the two outputs of the 1st pulse-modulation, phase-adjustable, 2-output transmitter 25a and the antinode position(s) of the 1st standing wave is determined.

[Step 3] The data required in the adjustment of the antinode position(s) of the 2nd standing wave that is generated when the 3rd and the 4th powers are supplied to the pair of electrodes 2, 4 are determined. Specifically, the relationship between the setting value of the phase difference of the two outputs of the 2nd pulse-modulation, phase-adjustable, 2-output transmitter 25b and the antinode position(s) of the 2nd standing wave is determined.

[Step 4] The 1st standing wave and the 2nd standing wave are generated, and the target i-type microcrystalline silicon film is deposited.

[Step 1]

In Figs. 9 and 10, the substrate 11 is positioned on the 2nd electrode 4 beforehand and a vacuum pump 10, which is not shown, is operated to remove the contaminated gas in the vacuum vessel 1. Then the pressure is maintained at 5.0 Torr (665 Pa) while continuing to supply SiH4 gas through raw material gas supply pipe 8 at 0.8 to 1.0 SLM (gas flow calculated in standard condition: L/minute), for example, 0.8 SLM, and hydrogen at 5.0 SLM. The substrate temperature is held in the range ranging from 100°C to 350°C, for example, at 220°C.

The size of substrate 11 is adapted to the size of the 1st electrode and is set to 1.65-m length x 0.3-m width (4-mm thick). Next, for example, when the frequency of the 1st power and the 2nd power is 100 MHz, the pulse width Hw = 250 $\mu$sec, and the pulse period T0 = 1 msec, then the total power of 500 to 1000 W, for example, 500 W is supplied. Since the pulse width Hw is 250 $\mu$sec and pulse period T0 is 1 msec, the duty ratio is 250 $\mu$sec/1 msec = 0.25.

The phase difference between the two outputs of the 1st pulse-modulation, phase-adjustable, 2-output transmitter 25a is set to, for example, zero, the pulse width Hw = 250 μsec and the pulse period T0 = 1 msec. The output of the 1st power amplifier 29a is set to 250 W. The output thereof is supplied to 1st and 3rd feeding points 20a, 21a through 1st impedance matching box 31a; 1st coaxial cable 32a; 1st LC bridge balanced-to-unbalanced converter 40a; 5th and 6th coaxial cables 41a, 41b connected respectively to the two output terminals of 1st LC bridge balanced-to-unbalanced converter 40a; 7th and 8th coaxial cables 43a, 43b connected respectively through 3rd current introduction terminal 42 to 5th and 6th coaxial cables 41a, 41b; and core lines 43a, 43b [sic. 44a, 44b] of 7th and 8th coaxial cables 43a, 43b; and the output of the 2nd power amplifier 29b is set to 250 W, and the output thereof is supplied to 2nd and 4th feeding points 20b, 21b through 2nd impedance matching box 31b; 2nd coaxial cable 32b; 9th and 10th coaxial cables 46a, 46b connected respectively to the two output terminals of 2nd LC bridge balanced-to-unbalanced converter 40b; 11th and 12th coaxial cables 48a, 48b connected respectively through 4th current introduction terminal 47 to 9th and 10th coaxial cables 46a, 46b; and core lines 49a, 49b of 11th and 12th coaxial cables 48a, 48b.

In this case, by adjusting the 1st impedance matching box 31a and 2nd impedance matching box 31b, the reflected wave of the supplied power does not return to the upstream side of each of impedance matching boxes 31a, 31b, i.e., Pr shown in Fig. 4 does not return. Generally, even when the 1st and 2nd LC bridge balanced-to-unbalanced converters 40a, 40b are arranged on the downstream side, reflected wave Pr can be suppressed to approximately 1 to 3% of the travelling wave Pf.

Under the above conditions, when the plasma is generated for a time of approximately 4 to 6 minutes, i-type microcrystalline silicon film is deposited on the substrate 11. After the film deposition, substrate 11 is taken out from the vacuum vessel 1, and the film thickness distribution of the i-type microcrystalline silicon film is evaluated.

The film thickness distribution of the i-type microcrystalline silicon film deposited on substrate 11 becomes a sinusoidal distribution due to the generation of standing waves which is a phenomenon unique to VHF plasma as will be explained later.

This film deposition test is conducted 5 or 6 times, for example, with the phase difference of the two outputs of the 1st pulse-modulation, phase-adjustable, 2-output transmitter 25a as the parameter.

In the direction connecting 1st and 2nd feeding points 20a, 20b, the interval between the antinodes of the standing wave is measured. The distance between a position of maximum film thickness of the i-type microcrystalline silicon film deposited on substrate 11 and an adjacent position of maximum film thickness is measured.

This means that the interval is a value of one half of the wavelength λ during the plasma generation of the power used.

Based on the above measurement results, the wavelength reduction rate of the power used and the setting = 1.65 m of the distance between the 1st and 2nd feeding points are evaluated.

In the above measurement results, when the interval between the antinodes of the standing waves is different from 825 mm, for example, when the interval of the antinodes of the standing waves is 795 mm, the wavelength is λ = 795 mm x 2 = 1590 mm during the plasma generation of the power used. In this case, the wavelength reduction rate $\lambda/\lambda_o$ of the power used is determined to be

$$\lambda/\lambda_o = 1590 \text{ mm}/3000 \text{ mm} = 0.53$$

where λ is the wavelength during plasma generation of the power used, and $\lambda_o$ is the wavelength in vacuum of electromagnetic waves having a frequency of 100 MHz.

In this case, the setting = 1.65 m for the distance between the 1st and the 2nd feeding points does not match an integer multiple of one half of the wavelength λ for which the wavelength reduction rate is considered. Therefore, the setting of 1.65 m must be changed to, for example, 1590 mm.

Alternately, 0.53 as the wavelength reduction rate $\lambda/\lambda_o$ of the power used can be confirmed. This data can be used, and the 100 MHz frequency can be changed to 96 MHz.

Specifically, if the wavelength in vacuum of electromagnetic waves having a frequency of 96 MHz is considered to be 3.125 m and the wavelength reduction rate $\lambda/\lambda_o$ of the power used to be 0.53, the wavelength λ at the frequency of 96 MHz during plasma generation is λ = 0.53 x 3.125 m = 1656 mm.

In Step 1, as explained above, the wavelength of the power used under the film deposition conditions of the i-type microcrystalline silicon film is measured. Then based on this data, the distance between the 1st and 2nd feeding points 20a, 20b is confirmed to be an integer n times one half of the wavelength λ during plasma generation of the power used. In addition, the wavelength reduction rate of the power used for the measured wavelength is confirmed.

When the distance between 1st and 2nd feeding points 20a, 20b is not set to an integer n times one half of the wavelength λ during plasma generation of the power used, the distance between 1st and 2nd feeding points 20a, 20b is set again to satisfy the conditions.

To satisfy the above conditions, the frequency of the plasma generation power is changed.

Here, when the setting = 1.65 m for the distance between the 1st and the 2nd feeding points did not match an integer multiple of one half of the wavelength λ for which the wavelength reduction rate is considered, the frequency is changed to satisfy the above conditions. Specifically, 100 MHz is changed to 96 MHz.

Under the above film deposition conditions, the wavelength reduction rate $\lambda/\lambda_o = 0.53$ is found, and when the frequency is set to 96 MHz (3.125-m wavelength of electromagnetic waves in vacuum), the setting = 1.65 m for the distance between 1st and 2nd feeding points 20a, 20b nearly matches an integer multiple of one half of the wavelength λ, for which the wavelength reduction rate = 2 x λ/2 = 2 x 1656 mm/2 = 1.656 m is considered. The wavelength λ of frequency 96 MHz during plasma generation is λ = 0.53 x 3.125 m = 1656 mm.

The setting = 1.65 m for the distance between 3rd and 4th feeding points 21a, 21b is similar to the above description.

[Step 2]

In Figs. 9 and 10, substrate 11 is set on the 2nd electrode 4 in advance, and vacuum pump 10, which is not shown, is operated to remove the contaminated gas in vacuum vessel 1. Then the pressure is maintained at 5.0 Torr (665 Pa) while continuing to supply SiH4 gas through raw material gas supply pipe 8 at 0.8 to 1.0 SLM (gas flow calculated in standard condition: L/minute), for example, 0.8 SLM, and hydrogen at 5.0 SLM. The substrate temperature is held in the range from 100°C to 350°C, for example, at 220°C.

The size of substrate 11 is set to 1.5-m length x 0.25-m width (4-mm thickness). The size smaller than the size of the 1st electrode is based on the empirical knowledge that there is occurrence of no reproducibility in the plasma intensity due to edge effects at the ends of the electrode.

Next, when the frequency of the 1st and the 2nd powers is 96 MHz, pulse width Hw = 250 μsec, pulse period T0 = 1 msec, and a total power of 500 to 1000 W, for example, 500 W, is supplied. Since the pulse width Hw is 250 μsec, and the pulse period T0 is 1 msec, the duty ratio is 250 μsec/1 msec = 0.25.

The phase difference between the two outputs of the 1st pulse-modulation, phase-adjustable, 2-output transmitter 25a is set to, for example, zero, the pulse width Hw = 250 μsec and the pulse period T0 = 1 msec. The output of 1st power amplifier 29a is set to 250 W. The output thereof is supplied to 1st and 3rd feeding points 20a, 21a through 1st impedance matching box 31a; 1st coaxial cable 32a; 1st LC bridge balanced-to-unbalanced converter 40a; 5th and 6th coaxial cables 41a, 41b connected respectively to the two output terminals of 1st LC bridge balanced-to-unbalanced converter 40a; 7th and 8th coaxial cables 43a, 43b connected respectively through 3rd current introduction terminal 42 to 5th and 6th coaxial cables 41a, 41b; and core lines 43a, 43b of 7th and 8th coaxial cables 43a, 43b; and the output of 2nd power amplifier 29b is set to 250 W, and the output thereof is supplied to 2nd and 4th feeding points 20b, 21b through 2nd impedance matching box 31b; 2nd coaxial cable 32b; 9th and 10th coaxial cables 46a, 46b connected respectively to the two output terminals of the 2nd LC bridge balanced-to-unbalanced converter 40b; 11th and 12th coaxial cables 48a, 48b connected respectively through 4th current introduction terminal 47 to 9th and 10th coaxial cables 46a, 46b; and core lines 49a, 49b of 11th and 12th coaxial cables 48a, 48b.

In this case, by adjusting 1st impedance matching box 31a and 2nd impedance matching box 31b, the reflected wave of the supplied power does not return to the upstream side of each of impedance matching boxes 31a, 31b, i.e., Pr shown in Fig. 4 does not return. Generally, even when 1st and 2nd LC bridge balanced-to-unbalanced converters 40a, 40b are arranged on the downstream side, reflected wave Pr can be suppressed to approximately 1 to 3% of the travelling wave Pf.

Under the above conditions, when the plasma is generated for a time of approximately 4 to 6 minutes, i-type microcrystalline silicon film is deposited on substrate 11. The film thickness distribution of the i-type microcrystalline silicon film deposited on substrate 11 becomes a sinusoidal distribution due to the generation of standing waves which is a phenomenon unique to VHF plasma as will be explained below.

The voltage wave of the 1st power supplied in the pulse form through the 1st and 3rd feeding points 20a, 21a and the voltage wave of the 2nd power supplied in the pulse form through 2nd and 4th feeding points 20b, 21b are oscillated from the same power supply and are transmitted in opposing directions in a space between the electrodes. In other words, the two waves are transmitted from mutually opposite directions and suppressed each other to generate an interference phenomenon.

Here, the voltage waves of the 1st and the 2nd powers supplied between the 1st and the 2nd electrodes are explained. Fig. 11 is a conceptual drawing of 1st and 3rd feeding points 20a, 21a and the pair of electrodes 2, 4 related to the apparatus for the second exemplary embodiment of the present invention. In Fig. 11, the voltage wave Ya between the core line 44a of 7th coaxial cable 43a and the outer conductor thereof is expressed by

$$Ya(t) = \sin(\omega t + 2\pi x/\lambda)$$

Voltage wave Yb between core line 44b of 8th coaxial cable 43b and the outer conductor thereof when the phase is changed to be delayed by 180° by 1st LC bridge balanced-to-unbalanced converter 40a is expressed by

$$Yb(t) = \sin(\omega t + 2\pi x/\lambda - 180°)$$

Thus, for example, if 2nd electrode 4 is the reference and the temporal changes in the voltage waves between the 1st and the 2nd electrodes are examined, the following results.

$$Y(t) = Ya(t) - Yb(t)$$
$$= 2 \sin(\omega t + 2\pi x/\lambda)$$

That is, the amplitudes between the 1st and the 2nd electrodes are doubled compared to the amplitudes of the voltages of the voltage waves Ya and Yb between the core lines of the 7th and the 8th coaxial cables 43a, 43b and the outer conductors thereof.

In the below, the temporal changes in the voltage waves between the 1st and the 2nd electrodes based on 2nd electrode 4, namely, the relationship of

$$Y(t) = Ya(t) - Yb(t)$$
$$= 2 \sin(\omega t + 2\pi x/\lambda)$$

is explained.

In Fig. 10, the distance in the direction from the 1st feeding point 20a side toward 2nd feeding point 20b is set to x, then the voltage wave transmitted in the positive direction of x is Y11(x, t), and the voltage wave transmitted in the negative direction of x, that is, the voltage wave transmitted from the 2nd feeding point 21a [sic. 20b] side toward 1st feeding point 20a, is Y12(x, t) and are expressed as follows.

$$Y11(x, t) = 2V1 \bullet \sin(\omega t + 2\pi x/\lambda)$$

$$Y12(x, t) = 2V1 \bullet \sin\{\omega t - 2\pi(x - L0)/\lambda + \Delta\delta\}$$

where 2V1 is the amplitude of the voltage waves; $\omega$, the angular frequency of the voltage; $\lambda$, the wavelength of the voltage wave; t, the time; L0, the interval between the 1st and the 2nd feeding points; and $\Delta\delta$, the phase difference between the voltage wave of the 1st power and the voltage wave of the 2nd power. The composite wave Y1(x, t) of the two voltage waves becomes the following equation.

$$Y1(x, t) = Y11(x, t) + Y12(x, t)$$
$$= 4 \bullet V1 \cos\{2\pi(x - L0/2)/\lambda - \Delta\delta/2\} \bullet \sin\{\omega t + (\pi L0/\lambda + \Delta\delta/2)\}$$

The composite wave Y1(x, t) has the following properties described next. When $\Delta\delta = 0$, the intensity of the generated plasma is stronger in the centre section (x = L0/2) between the feeding points and becomes weaker as departing away from the centre section. When $\Delta\delta > 0$, the strong part of the plasma shifts toward one feeding point side, and when $\Delta\delta < 0$, the strong part of the plasma shifts toward the other feeding point side.

Here, the composite wave of the two voltage waves of Y11(x, t) and Y12(x, t) is called the 1st standing wave Y1(x, t).

The intensity of the power between the pair of electrodes is proportional to the square of the amplitude of the composite wave Y1(x, t) of the voltage. Namely, the intensity I1(x, t) of the power is expressed by

$$I1(x, t) \propto \cos^2\{2\pi(x - L0/2)/\lambda - \Delta\delta/2\}$$

I1(x, t) is illustrated conceptually by the solid line in Fig. 7 (intensity distribution of the 1st standing wave).

After film deposition under the above conditions, substrate 11 is taken out of vacuum vessel 1, and the film thickness distribution of the i-type microcrystalline silicon film is evaluated.

The film thickness distribution of the i-type microcrystalline silicon film deposited on substrate 11 becomes a sinusoidal distribution due to the generation of standing waves which is a phenomenon unique to VHF plasma.

The film deposition test is conducted repeatedly with a parameter of the phase difference of the two outputs of 1st pulse-modulation, phase-adjustable, 2-output transmitter 25a.

In the direction connecting 1st and 2nd feeding points 20a, 20b, the relationship between the distance from the centre point of substrate 11 to the position of the maximum thickness in the sinusoidal film thickness distribution and the phase difference between the two outputs of 1st pulse-modulation, phase-adjustable, 2-output transmitter 25a are determined as data.

For example, when the position of the broken line in Fig. 8A is at the centre point of substrate 11, the phase difference to match the centre point thereof to the position of the maximum thickness of the sinusoidal film thickness distribution is found to be, for example, $\Delta\delta1$.

When the film is deposited with a sinusoidal film thickness distribution, each of the distance between 1st and 2nd feeding points 20a, 20b and the distance between 1st and 2nd [*sic,* 3rd and 4th] feeding points 21a, 21b matches an integer multiple of one half of the wavelength $\lambda$ for which the wavelength reduction rate is considered. In addition, because the position is at the end of the pair of electrodes, the resonance phenomenon appears in which standing waves are easily generated where both ends of the pair of electrodes are the antinodes or the nodes.

This resonance phenomenon, as described above, means that the generation of stable plasma is easy, and the action in which the supplied power is effectively consumed in the plasma generation is present.

[Step 3]

In Figs. 9 and 10, substrate 11 is positioned on the 2nd electrode 4 beforehand and vacuum pump 10, which is not shown, is operated to remove the contaminated gas in vacuum vessel 1. Then the pressure is maintained at 5.0 Torr (665 Pa) while continuing to supply SiH4 gas through raw material gas supply pipe 8 at 0.8 to 1.0 SLM (gas flow calculated in standard condition: L/minute), for example, 0.8 SLM, and hydrogen at 5.0 SLM. The substrate temperature is held in the range from 100°C to 350°C, for example, at 220°C.

The size of substrate 11 is set to 1.5-m length x 0.25-m width (4-mm thick). The size smaller than the size of the 1st electrode is based on the empirical knowledge that there is occurrence of no reproducibility in the plasma intensity due to edge effect at the ends of the electrode.

Next, when the frequency of the 3rd and the 4th powers is 96 MHz, pulse width Hw = 250 $\mu$sec, pulse period T0 = 1 msec, then a total power of 500 to 1000 W, for example, 500 W, is supplied.

The phase difference between the two outputs of 2nd pulse-modulation, phase-adjustable, 2-output transmitter 25b is set to, for example, zero, the pulse width Hw = 250 $\mu$sec and the pulse period T0 = 1 msec. The output of 1st power amplifier 29a is set to 250 W. The output thereof is supplied to 1st and 3rd feeding points 20a, 21a through 1st impedance matching box 31a; 1st coaxial cable 32a; 1st LC bridge balanced-to-unbalanced converter 40a; 5th and 6th coaxial cables 41a, 41b connected respectively to the two output terminals of 1st LC bridge balanced-to-unbalanced converter 40a; 7th and 8th coaxial cables 43a, 43b connected respectively through 3rd current introduction terminal 42 to 5th and 6th coaxial cables 41a, 41b; and core lines 43a, 43b [sic. 44a, 44b] of 7th and 8th coaxial cables 43a, 43b; and the output of 2nd power amplifier 29b is set to 250 W, and the output thereof is supplied to 2nd and 4th feeding points 20b, 21b through 2nd impedance matching box 31b; 2nd coaxial cable 32b; 9th and 10th coaxial cables 46a, 46b connected respectively to the two output terminals of 2nd LC bridge balanced-to-unbalanced converter 40b; 11th and 12th coaxial cables 48a, 48b connected respectively through 4th current introduction terminal 47 to 9th and 10th coaxial cables 46a, 46b; and core lines 49a, 49b of 11th and 12th coaxial cables 48a, 48b.

In this case, by adjusting 1st impedance matching box 31a and 2nd impedance matching box 31b, the reflected wave of the supplied power does not return to the upstream side of each of impedance matching boxes 31a, 31b, i.e., Pr shown in Fig. 4 does not return. Generally, even when 1st and 2nd LC bridge balanced-to-unbalanced converters 40a, 40b are arranged on the downstream side, reflected wave Pr can be suppressed to approximately 1 to 3% of the travelling wave Pf.

Under the above conditions, when the plasma is generated for a time of approximately 4 to 6 minutes, i-type microcrystalline silicon film is deposited on substrate 11. As explained below, the film thickness distribution of the i-type microcrystalline silicon film deposited on substrate 11 becomes a sinusoidal distribution due to the generation of standing waves which is a phenomenon unique to VHF plasma.

The voltage wave of the 3rd power supplied in pulse form through the 1st and 3rd feeding points 20a, 21a and the voltage wave of the 4th power supplied in pulse form through 2nd and 4th feeding points 20b, 21b are oscillated from the same power supply and are transmitted counterwise in a space between the electrodes. In other words, the two waves are transmitted from mutually opposite directions and superposed to generate an interference phenomenon. In Fig. 10, the distance in the direction from the 1st feeding point 20a side toward 2nd feeding point 20b is set to x, then the voltage wave transmitted in the positive direction of x is Y11(x, t) [*sic,* Y21(x, t)], and the voltage wave transmitted in the negative direction of x, that is, the voltage wave transmitted from the 2nd feeding point 21a [sic. 20b] side toward 1st feeding point 20a, is Y12(x, t) [*sic,* Y22(x, t)] and are expressed as follows.

$$Y21(x, t) = 2V1 \bullet \sin(\omega t + 2\pi x/\lambda)$$

$$Y22(x, t) = 2V1 \bullet \sin\{\omega t - 2\pi(x - L0)/\lambda + \Delta\delta\}$$

where 2V1 is the amplitude of the voltage waves; $\omega$, the angular frequency of the voltage; $\lambda$, the wavelength of the voltage wave; t, the time; L0, the interval between the 1st and the 2nd feeding points; and $\Delta\delta$, the phase difference between the voltage wave of the 3rd power and the voltage wave of the 4th power. The composite wave Y2(x, t) of the two voltage waves becomes the following equation.

$$Y2(x, t) = Y21(x, t) + Y22(x, t)$$
$$= 4 \bullet V1 \cos\{2\pi(x - L0/2)/\lambda - \Delta\delta/2\} \bullet \sin\{\omega t + (\pi L0/\lambda + \Delta\delta/2)\}$$

The composite wave Y2(x, t) has the following properties. When $\Delta\delta = 0$, the intensity of the generated plasma is stronger in the centre section (x = L0/2) between the feeding points and becomes weaker when departing away from the centre section. When $\Delta\delta > 0$, the strong part of the plasma shifts toward one feeding point side, and when $\Delta\delta < 0$, the strong part of the plasma shifts toward the other feeding point side.

Here, the composite wave of the two voltage waves of Y21(x, t) and Y22(x, t) is called the 2nd standing wave Y2(x, t).

The intensity of the electric power between the pair of electrodes is proportional to the square of the amplitude of the composite wave Y2(x, t) of the voltage. The intensity 12(x, t) of the power is expressed by

$$I2(x, t) \propto \cos^2\{2\pi(x - L0/2)/\lambda - \Delta\delta/2\}$$

12(x, t) is represented conceptually by the broken line in Fig. 7 (intensity distribution of the 2nd standing wave).

After film deposition under the above conditions, substrate 11 is taken out of vacuum vessel 1, and the film thickness distribution of the i-type microcrystalline silicon film is evaluated.

As described earlier, the film thickness distribution of the i-type microcrystalline silicon film deposited on substrate 11 becomes a sinusoidal distribution due to the generation of standing waves which is a phenomenon unique to VHF plasma. Such film deposition test is conducted repeatedly with a parameter of the phase difference of the two outputs of the 2nd pulse-modulation, phase-adjustable, 2-output transmitter 25b as the parameter.

In the direction connecting 1st and 2nd feeding points 20a, 20b, the relationship between the distance from the centre point of substrate 11 to the position of the maximum thickness in the sinusoidal film thickness distribution and the phase difference between the two outputs of the 1st [*sic,* 2nd] pulse-modulation, phase-adjustable, 2-output transmitter 25b is found as data.

For example, when the position of the broken line in Fig. 8B is at the centre point of substrate 11, the phase difference to set at the position a quarter of the wavelength $\lambda$, i.e., $\lambda/4$, in the direction from the centre point toward 2nd feeding point 20a [*sic,* 20b] is found to be, for example, $\Delta\delta2$. From the measurement result in Step 1, $\lambda/4 = 414$ mm.

When film is deposited with a sinusoidal film thickness distribution, each of the distance between 1st and 2nd feeding points 20a, 20b and the distance between 1st and 2nd [*sic,* 3rd and 4th] feeding points 21a, 21b matches an integer multiple of one half of the wavelength $\lambda$ for which the wavelength reduction rate is considered. In addition, because the position is at the end of the pair of electrodes, the resonance phenomenon appears in which standing waves are easily generated where both ends of the pair of electrodes are the antinodes or the nodes.

This resonance phenomenon, as described above, means that the generation of stable plasma is easy, and the action in which the supplied power is effectively consumed in the plasma generation is present.

[Step 4]

Based on the results of Steps 1 to 3 above, the step of depositing the target i-type microcrystalline silicon film is entered. First, in Figs. 9 and 10, substrate 11 is positioned on 2nd electrode 4 beforehand and vacuum pump 10, which is not shown, is operated to remove the contaminated gas in vacuum vessel 1. Then the pressure is maintained at 5.0 Torr (665 Pa) while continuing to supply SiH4 gas through raw material gas supply pipe 8 at 0.8 to 1.0 SLM (gas flow calculated in standard condition: L/minute), for example, 0.8 SLM, and hydrogen at 5.0 SLM. The substrate temperature is held in the range from 100°C to 350°C, for example, at 220°C.
The size of substrate 11 is set to 1.5-m length x 0.25-m width (4-mm thick).
Next, the phase difference of the two outputs of the 1st pulse-modulation, phase-adjustable, 2-output transmitter 25a, namely, the sinusoidal waves having a frequency of 96 MHz, is set to $\Delta\delta1$ found in the data obtained in Step 2. The pulse modulation sets the pulse width Hw and the pulse period T0 in 1st power Y11(t) and 2nd power Y12(t) shown in Figs. 5 and 6 to, for example, Hw = 250 $\mu$sec and T0 = 1 msec. The 1st and 2nd powers are supplied as 250 W each. First power Y11(t) is supplied to 1st and 3rd feeding points 20a, 21a, and 2nd power Y12(t) is supplied to 2nd and 4th feeding points 20b, 21b.
The phase difference between the two outputs of the 2nd pulse-modulation, phase-adjustable, 2-output transmitter 25b, namely, the sinusoidal waves having the frequency of 96 MHz, is set to $\Delta\delta2$ found in the data obtained in Step 3. In addition, the pulse modulation is set so that the pulse width Hw and the pulse period T0 in 3rd power Y21(t) and 4th power Y22(t) shown in Figs. 5 and 6 are, for example, pulse width Hw = 250 $\mu$sec and the pulse period T0 = 1 msec, and a half period from the pulse rising time of the pulse modulation of Y11(t) and Y12(t), namely, to rise at a time delayed by TO/2, is set. The 3rd and 4th powers are each 250 W. The 3rd power Y21(t) is supplied to the 1st and 3rd feeding points 20a, 21a, and the 4th power Y22(t) is supplied to 2nd and 4th feeding points 20b, 21b.
Here the Hw, T0, and pulse rising time of the pulse modulation are changed from the above numerical values, and the film is deposited, and several sets of film deposition data can be compared.

When the four powers are supplied between the pair of electrodes 2, 4, as described previously, Y11(x, t) and Y12(x, t) interfere to form the 1st standing wave Y1(x, t). Y21(x, t) and Y22(x, t) interfere to form the 2nd standing wave Y2(x, t).
However, Y11(x, t) does not interfere with Y21(x, t) and Y22(x, t), due to the temporal separation. Similarly, Y12(x, t) does not interfere with Y21(x, t) and Y22(x, t).
Consequently, if the general film deposition time of at least several seconds which is much longer than the period T0 of the pulse modulation is considered, the intensity distribution of the power generated between the pair of electrodes 2, 4 is formed to overlap the intensity distribution I1(x, t) of the 1st standing wave Y1(x, t) and the intensity distribution 12 (x, t) of 2nd standing wave Y2(x, t). Fig. 7 conceptually shows this aspect.
When the centre point of the substrate is the origin of the x axis, the direction from the 1st feeding point 20a side to the 2nd feeding point 20b is set as the positive direction. The intensity distribution I1(x, t) of the 1st standing wave Y1(x, t) is

$$I1(x, t) = B\cos^2\{2\pi x/\lambda\}$$

where B is the proportionality constant.
The intensity distribution I2(x, t) of the 2nd standing wave W2(x, t) [*sic,* Y2(x, t)] is

$$I2(x, t) = B\sin^2\{2\pi x/\lambda\}$$

The intensity distribution I(x, t) of the power generated between (across) the pair of electrodes 2, 4 is

$$I(x, t) = B\cos^2\{2\pi x/\lambda\} + B\sin^2\{2\pi x/\lambda\} = B$$

This result shows that the intensity distribution I(x, t) of the power generated between the pair of electrodes 2, 4 is a constant value that does not depend on x, that is, the position in the transmission direction of the power, and is uniform. In addition, the intensity is independent of the frequency and becomes uniform.
The above plasma generation method can be a method that is not affected by the standing waves, that is, a plasma generation method free of standing waves.
When SiH4 gas is formed into plasma, radicals such as SiH3, SiH2, SiH, H present in the plasma are dispersed by the dispersion phenomenon and adhere to the surface of substrate 11 to deposit i-type microcrystalline silicon film.

As described above, the distribution of power between the pair of electrodes 2, 4 is uniform on average over time, and the deposited film becomes uniform.

In the apparatus and method of the present invention, a uniform film thickness distribution can be formed even when the target substrate has a size exceeding one half of the wavelength $\lambda$. This means that substrate even when the target is a substrate having a size exceeding one half of the wavelength $\lambda$ that is regarded as impossible in a conventional VHF plasma surface treatment apparatus and method, the present invention can achieve a uniform distribution.

In addition, each of the distance between 1st and 2nd feeding points 20a, 20b and the distance between 3rd and 4th feeding points 21a, 21b matches an integer multiple of one half of the wavelength $\lambda$ for which the wavelength reduction rate is considered. Because the position is at the end of the pair of electrodes, standing waves are readily generated where both ends of the pair of electrodes are the antinodes and the nodes.

This means that in addition to ease of stable plasma generation, the supplied power is effectively consumed in the plasma generation.

Consequently, the above is a breakthrough discovery in the application field of VHF plasma CVD apparatus, and its practical value is immense.

As to the film deposition rate of the i-type microcrystalline silicon film deposited in Step 4 approximately 2.5 to 3.0 nm/s is obtained at the supplied power density 2.02 kW/m$^2$ (1 kW/0.495 m$^2$).

In addition, at the supplied power density of 3.23 kW/m$^2$ (1.6 kW/0.495 m$^2$), about 3 to 3.5 nm/s is obtained.

The supplied power density of 2.02 kW/m$^2$ (1 kW/0.495 m$^2$) for the film deposition rate of 2.5 to 3.0 nm/s and the supplied power density of 3.23 kW/m$^2$ (1.6 kW/0.495 m$^2$) for a film deposition rate of about 3 to 3.5 nm/s are small numerical values compared to the supplied power density in conventional technologies.

This means that due to the action of the resonance phenomenon described above, power supply is realised that suppressed the power losses when power is supplied to the pair of electrodes.

In the second exemplary embodiment of the present invention, because the size of the 1st electrode is 1.65 m x 0.3 m (20-mm thickness) and the size of the 2nd electrode is 1.65 m x 0.4 m (150-mm thickness), the substrate size is limited to approximately 1.5 m x 0.25 m x 4-mm thickness. However, if the number of the 1st electrodes 2 increases, the size of the 2nd electrode increases, and the same number of power supply devices (power supply system shown in Fig. 9) as the 1st electrodes 2 is set up, naturally, the width of the substrate can be expanded.

In addition, in the manufacture of an integrated tandem thin-film silicon solar cell, if the film thickness distribution is within $\pm10\%$, there is no problem in performance. According to the above exemplary embodiment, even if a power source frequency of 96 MHz is used, uniformity is possible in the intensity distribution I(x, t) of the power between the pair of electrodes 2, 4 which was not possible with the conventional technologies. In other words, a film thickness distribution within $\pm10\%$ can be realised.

Moreover, the supplied power does not leak to outside of the pair of electrodes, and consumption is in the plasma generation between the pair of electrodes. Therefore, the power losses are markedly small compared to the conventional technologies.

This means that the engineering value is significant in relation to the improved productivity and the lower costs in manufacturing field of thin-film silicon solar cells, thin-film transistors, and light exposure drum.

**Claims**

1. A high-frequency plasma CVD apparatus that forms a thin film on a surface of a substrate placed in a vacuum vessel by using plasma, **characterised in that** the CVD apparatus comprises:

   a 1st feeding point arranged at an end of an electrode and a 2nd feeding point arranged at a position opposing said 1st feeding point in transmission of power wave; and
   a high-frequency power feed means wherein an interval between said 1st feeding point and said 2nd feeding point is set to an integer n times one half of wavelength, i.e., n$\lambda$/2, for which a wavelength reduction rate of power used is considered, and a 1st standing wave whose antinode positions matching positions of said 1st and 2nd feeding points and a 2nd standing wave whose node positions matching positions of said 1st and 2nd feeding points are generated alternately in time.

2. A high-frequency plasma CVD apparatus that forms a thin film on a surface of a substrate positioned in a vacuum vessel by using plasma, **characterised in that** the CVD apparatus comprises:

   a 1st feeding point arranged at an end of an electrode and a 2nd feeding point arranged at a position opposing said 1st feeding point in transmission of power wave;
   a high-frequency power feed means in which an interval between said 1st feeding point and said 2nd feeding point is set to an integer n times one half of wavelength $\lambda$, i.e., $n\lambda/2$, for which a wavelength reduction rate of power used is considered, and a 1st standing wave whose antinode positions matching positions of said 1st and 2nd feeding points and a 2nd standing wave whose node positions matching positions of said 1st and 2nd feeding points are generated alternately in time; and

a balanced-to-unbalanced converter for converting an unbalanced power transmission path into a balanced power transmission path.

3.  A high-frequency plasma CVD apparatus **characterised by** comprising:

a vacuum vessel that is provided with an exhaust system and adapted to set a substrate therein;
a raw material gas supply system that supplies raw material gas to the interior of the vacuum vessel;
a pair of electrodes formed from an ungrounded electrode and a grounded electrode for generating plasma;
a 2-output high-frequency power source in which the two standing waves are generated alternately in time between said pair of electrodes and can set an interval between antinode positions of one of said two standing waves and antinode positions of the other to a quarter of wavelength $\lambda$, i.e., $\lambda/4$, of power used, for which a wavelength reduction rate is considered;
1st and 2nd impedance matching boxes that match impedances on the respective output side of said 2-output high-frequency power source;
1st and 2nd coaxial cables for transmitting the outputs of said 1st and 2nd impedance matching boxes to respective electrodes; and
1st and 2nd feeding points which connect to said 1st and 2nd coaxial cables, respectively, and are alternately set at opposite positions at the ends of said ungrounded electrode; wherein
distance between said 1st and 2nd feeding points is set to an integer n times one half of wavelength $\lambda$, i.e., $n\lambda/2$, of power used for which a wavelength reduction rate is considered.

4.  A high-frequency plasma CVD apparatus **characterised by** comprising:

a vacuum vessel that is adapted to set a substrate therein and has an exhaust system;
a raw material gas supply system that supplies raw material gas to the interior of the vacuum vessel;
a pair of electrodes formed of an ungrounded electrode and a grounded electrode for generating plasma;
a 1st high-frequency transmitter with two outputs that can arbitrarily set pulse modulation and set any phase difference for voltages of said two outputs;
a 2nd high-frequency transmitter with two outputs that can transmit a pulse-modulated sinusoidal wave having a different time band for transmission than a pulse-modulated sinusoidal wave output from said 1st high-frequency transmitter, and can set any phase difference for the voltages of said two outputs;
a 1st signal coupler that couples one of the two output signals of said 1st high-frequency transmitter and one of the two output signals of said 2nd high-frequency transmitter;
a 2nd signal coupler that couples the other of the two output signals of said 1st high-frequency transmitter and the other of the two output signals of said 2nd high-frequency transmitter;
a 1st power amplifier that amplifies an output of said 1st signal coupler;
a 2nd power amplifier that amplifies an output of said 2nd signal coupler;
a 1st impedance matching box that can match impedance on the output side of said 1st power amplifier and transmits the outputs supplied by said 1st power amplifier to said pair of electrodes;
a 2nd impedance matching box that can match impedance on the output side of said 2nd power amplifier and transmits the output supplied by said 2nd power amplifier to said pair of electrodes;
a 1st coaxial cable for connecting an output terminal of said 1st impedance matching box to said pair of electrodes;
a 2nd coaxial cable for connecting an output terminal of said 2nd impedance matching box to said pair of electrodes;
a 1st feeding point that is positioned at the end of said ungrounded electrode, is connected to a core line of said 1st coaxial cable, and is supplied with power from said 1st coaxial cable;
a 2nd feeding point that is positioned at the end of the ungrounded electrode opposite said 1st feeding point, is connected to a core line of said 2nd coaxial cable, and is supplied with power from said 2nd coaxial cable; and
a distance between said 1st and 2nd feeding points is set to an integer n times one half of wavelength $\lambda$, i.e., $n\lambda/2$, of power used for which a wavelength reduction rate is considered.

5.  A high-frequency plasma CVD apparatus **characterised by** comprising:

a vacuum vessel that is adapted to set a substrate therein and has an exhaust system;,

a raw material gas supply system that supplies raw material gas to the interior of the vacuum vessel;

a pair of electrodes formed from an ungrounded electrode and a grounded electrode for generating plasma;

a two-output high-frequency power source that alternately generates in time two standing waves between said pair of electrodes and can set an interval between antinode positions of one of said two standing waves and antinode positions of the other to a quarter of the wavelength $\lambda$, i.e., $\lambda/4$, of power used for which a wavelength reduction rate is considered;

1st and 2nd impedance matching boxes for matching impedance of each output side of said 2-output high-frequency power source;

1st and 2nd balanced-to-unbalanced converters that are connected to said 1st and 2nd impedance matching boxes, respectively, and convert the power transmission circuit to a balanced transmission mode from an unbalanced transmission mode;

1st and 2nd balanced transmission lines for transmitting outputs of said 1st and 2nd balanced-to-unbalanced converters to the respective electrodes; and

1st and 2nd feeding points that are connected to said 1st and 2nd balanced transmission lines, respectively, and are set at mutually opposing positions at the ends of said ungrounded electrode; and

has a structure wherein a distance between said 1st and 2nd feeding points is set to an integer n times one half of wavelength $\lambda$, i.e., $n\lambda/2$, of power used for which a wavelength reduction rate is considered.

6. A high-frequency plasma CVD apparatus **characterised by** comprising:

a vacuum vessel that is adapted to set a substrate therein and provided with an exhaust system;

a raw material gas supply system that supplies raw material gas to the interior of the vacuum vessel;

a pair of electrodes formed of an ungrounded electrode and a grounded electrode for generating plasma;

a 1st high-frequency transmitter with two outputs that can optionally set pulse modulation and set any phase difference for the voltages of said two outputs;

a 2nd high-frequency transmitter with two outputs that can transmit a pulse-modulated sinusoidal wave that is transmitted in a different time band than a pulse-modulated sinusoidal wave output from said 1st high-frequency transmitter, and arbitrarily set phase difference of voltages at said two outputs;

a 1st signal coupler that couples one of the two output signals of said 1st high-frequency transmitter and one of the two output signals of said 2nd high-frequency transmitter;

a 2nd signal coupler that couples the other of the two output signals of said 1st high-frequency transmitter and the other of the two output signals of said 2nd high-frequency transmitter;

a 1st power amplifier that amplifies the output of said 1st signal coupler;

a 2nd power amplifier that amplifies the output of said 2nd signal coupler;

a 1st impedance matching box that can match impedance on the output side of said 1st power amplifier, and transmits the output supplied by said 1st power amplifier to said pair of electrodes;

a 2nd impedance matching box that can match impedance on the output side of said 2nd power amplifier and transmits the output supplied by said 2nd power amplifier to said pair of electrodes;

a 1st balanced-to-unbalanced converter that transmits the output of said 1st impedance matching box to said pair of electrodes and converts the power transmission circuit from the unbalanced transmission mode to a balanced transmission mode;

a 1st coaxial cable for connecting the output terminal of said 1st impedance matching box to said 1st balanced-to-unbalanced converter,

a 2nd balanced-to-unbalanced converter that transmits the output of said 2nd impedance matching box to said pair of electrodes and converts the power transmission circuit from the unbalanced transmission mode to a balanced transmission mode,

a 2nd coaxial cable for connecting an output terminal of said 2nd impedance matching box to said 2nd balanced-to-unbalanced converter;

a 1st balanced transmission line that supplies the output of said 1st balanced-to-unbalanced converter to said pair of electrodes, that is, a 1st balanced transmission line having a constitution in which at least outer conductors of the two coaxial cables having roughly the same lengths are short-circuited at least at both ends, one end of each core line of said two coaxial cables is an input, and the other end of each core line is an output,

a 2nd balanced transmission line that supplies the output of said 2nd balanced-to-unbalanced converter to said pair of electrodes, that is, a 2nd balanced transmission line having a constitution in which at least outer conductors of the two coaxial cables having roughly the same lengths are short-circuited on at least both ends, one end of each core line of said two coaxial cables is an input, and the other end of each core line is an output;

a 1st feeding point that is positioned at an end of said ungrounded electrode, is connected to one of the two core lines at the output of said 1st balanced transmission line, and is supplied with power from said 1st balanced transmission line;

a 3rd feeding point that is positioned at an end of said grounded electrode and positioned closest to the 1st feeding point, is connected to the other of the two core lines at the output of said 1st balanced transmission line, and is supplied with power from said 1st balanced transmission line,

a 2nd feeding point that is positioned at the end of the ungrounded electrode opposite said 1st feeding point, is connected to one of the two core lines at the output of said 2nd balanced transmission line, and is supplied with power from said 2nd balanced transmission line; and

a 4th feeding point that is positioned at the end of the grounded electrode opposite said 3rd feeding point, is connected to the other of the two core lines at the output of said 2nd balanced transmission line, and is supplied with power from said 2nd balanced transmission line; and

wherein a distance between said 1st and 2nd feeding points is set to an integer n times one half of wavelength $\lambda$, i.e., $n\lambda/2$, of power used for which a wavelength reduction rate is considered.

7. A method of manufacturing semiconductor thin films for thin-film silicon solar cells using a high-frequency plasma CVD apparatus having a power source frequency of a VHF range (30 - 300 MHz), **characterised in that** the method of manufacturing semiconductor thin films based on plasma CVD uses the high-frequency plasma CVD apparatus described in any one of claims 1 to 6 as said high-frequency plasma CVD apparatus to manufacture a semiconductor thin film for thin-film silicon solar cells.

8. A high-frequency plasma CVD method that uses plasma which has a power source frequency of a VHF range (30 - 300 MHz)to form thin film on a surface of a substrate positioned in a vacuum vessel, **characterised in that**
a 1st feeding point is arranged on one end of the ungrounded electrode;
a 2nd feeding point is arranged at a position opposite said \st feeding point in transmission of power wave and at the other end of said ungrounded electrode;
a distance between said 1st and 2nd feeding points is set to an integer n times one half of wavelength $\lambda$, i.e., $n\lambda/2$, for which a wavelength reduction rate of power used is considered: and
a 1st standing wave that matches antinode positions to the positions of said 1st and 2nd feeding points and a 2nd standing wave that matches node positions to the positions of said 1st and 2nd feeding points are alternately generated in time.

9. A high-frequency plasma CVD method that uses plasma which has a power source frequency in a VHF range (30 - 300 MHz) to form thin film on a surface of a substrate positioned in a vacuum vessel, **characterised by** comprising:

a first step of setting an interval between a 1st feeding point arranged at an end of an ungrounded electrode and a 2nd feeding point arranged at a position opposite said 1st feeding point in transmission of power wave to an integer n times one half of wavelength $\lambda$, i.e., $n\lambda/2$, of power used for which a wavelength reduction rate is considered;

a second step of determining conditions for generating a 1st standing wave that matches antinode positions to the respective positions of said 1st and 2nd feeding points;

a third step of determining conditions for generating a 2nd standing wave that matches node positions to the respective positions of said 1st and 2nd feeding points; and

a fourth step of forming a target thin film on said substrate by alternately generating said 1st and 2nd standing waves determined, respectively, in said second and third steps in mutually different time bands.

FIG.1

FIG.2

FIG.3

FIG.4

FIG.5

EP 2 237 310 A1

FIG.6

FIG.7

The First Standing Wave

The Second Standing Wave

Intensity of Power between Electrodes

1.0

0.5

0

-0.2  -0.1  0  0.1  0.2  0.3  0.4  0.5λ

X

FIG.8A

FIG.8B

λ/4

FIG.9

FIG.10

EP 2 237 310 A1

FIG.11

FIG.12

$$I = I_1 + I_2$$

49

FIG.13

## INTERNATIONAL SEARCH REPORT

| International application No. |
| --- |
| PCT/JP2008/066171 |

A. CLASSIFICATION OF SUBJECT MATTER
*H01L21/205*(2006.01)i, *C23C16/505*(2006.01)i

According to International Patent Classification (IPC) or to both national classification and IPC

B. FIELDS SEARCHED

Minimum documentation searched (classification system followed by classification symbols)
H01L21/205, C23C16/505

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2007-103970 A (Masayoshi MURATA),<br>19 April, 2007 (19.04.07),<br>Par. Nos. [0016] to [0224]; Figs. 1 to 5<br>(Family: none) | 4<br>6,7<br>1-3,5,8,9 |
| Y | JP 2006-228933 A (Masayoshi MURATA),<br>31 August, 2006 (31.08.06),<br>Par. Nos. [0017] to [0147]; Figs. 1 to 8<br>(Family: none) | 6,7 |
| A | JP 2006-332704 A (Masayoshi MURATA),<br>07 December, 2006 (07.12.06),<br>Par. Nos. [0016] to [0129]; Figs. 1 to 8<br>(Family: none) | 1-3,5,8,9 |

☐ Further documents are listed in the continuation of Box C.    ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>20 October, 2008 (20.10.08) | Date of mailing of the international search report<br>28 October, 2008 (28.10.08) |
| --- | --- |
| Name and mailing address of the ISA/<br>Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006216921 A
- JP 3316490 B
- JP 3611309 B
- JP H2005123203 A
- JP 3590955 B

### Non-patent literature cited in the description

- **M. Kondo ; M. Fukawa ; L. Guo ; A. Matsuda.** High rate growth of microcrystalline silicon at low temperatures. *Journal of Non-Crystalline Solids,* 2000, vol. 266-269, 84-89
- **J.A. Baggerman ; R.J. Visser ; E.J.H. Collart.** Power dissipation measurements in a low-pressure N2 radio-frequency discharge. *J. Appl. Phys.,* 15 July 1994, vol. 76 (2), 738-746
- **H. Takatsuka ; Y. Yamauchi ; K. Kawamura ; H. Mashima ; Y. Takeuchi.** World's largest amorphous silicon photovoltaic module. *Thin Solid Films,* 2006, vol. 506-507, 13-16
- **K. Kawamura ; H. Mashima ; Y. Takeuchi ; A. Takano ; M. Noda ; Y. Yonekura ; H. Takatuka.** Development of large-area a-S:H films deposition using controlled VHF plasma. *Thin Solid Films,* 2006, vol. 506-507, 22-26